(19) Europäisches Patentamt
European Patent Office
Office européen des brevets

(11) EP 2 458 534 A1

(12) EUROPEAN PATENT APPLICATION

(43) Date of publication:
30.05.2012 Bulletin 2012/22

(51) Int Cl.:
G06Q 10/00 (2012.01)

(21) Application number: 11189006.7

(22) Date of filing: 14.11.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 26.11.2010 JP 2010263792

(71) Applicant: Konica Minolta Business
Technologies, Inc.
Tokyo 100-0005 (JP)

(72) Inventor: Yamade, Yasushi
Yokohama, Kanagawa (JP)

(74) Representative: Higgs, Jonathan
Urquhart-Dykes & Lord LLP
3rd Floor
33 Glasshouse Street
London W1B 5DG (GB)

(54) **Printer layout support device**

(57) Disclosed is a layout support device including: a route obtaining unit for each of users who use an image forming apparatus, for obtaining a route in a predetermined area in which the image forming device is installed; a recommended arrangement calculating unit for calculating a recommended arrangement of the image forming device in the predetermined area in accordance with a positional relation between the route of each user obtained by the route obtaining unit and a position in which the image forming device is installed; and a display unit for displaying the recommended arrangement calculated by the recommended arrangement calculating unit.

FIG.1

**Description**

BACKGROUND OF THE INVENTION

Field of the Invention

The present invention relates to a layout support device for improving the arrangement of an image forming device in an office or the like.

Description of Related Art

In an office or the like, various types of equipments used in a work are installed. A technology for providing the information relating to each arrangement of the equipments, has been known.

For example, there is a technology for analyzing a work style in an office (such as, trading type, project type, concentrate type, or transaction type of work style) to determine the equipments which are necessary for the office. Further, in the technology, it is judged whether the determined equipments can be installed in the office, and the layout of the office is carried out (See Japanese Patent Application Publication No. 2001-184375).

In an office in which an image forming device, such as a copy machine, a multi function peripheral or the like, is installed, a user moves between the user's seat and various destinations, including moving to the image forming device to use it or to pick up an output obj ect. As examples of the user' s movement between the user's seat and various destinations, a user moves from an office to which the user belongs (i.e., his/her workplace) to another office (another section), a conference room or the like. Alternatively, the user moves to a shelf or common space in the office. In case that the user wants to stop by the image forming device during the above user' s movement, the user needs to detour if the image forming device is apart from the user's route between the user's seat and his/her destination; therefore, not only it is inconvenient for the user, but also the efficiency of the office work decreases.

Further, by the above technology in which the layout is carried out by analyzing a work style and by determining the arrangement of each equipment which is determined to be necessary for the office, it is not possible to meet user's demand that proper arrangement of the image forming device is determined in consideration of the user's route.

SUMMARY

One of the objects of the present invention is to provide a layout support device which can propose the arrangement of the image forming device, in which the user easily stops by the image forming device during the user's movement between the user's seat and various destinations.

To achieve at least one of the abovementioned objects, a layout support device reflecting one aspect of the present invention comprises:

> a route obtaining unit for each of users who use an image forming apparatus, for obtaining a route in a predetermined area in which the image forming device is installed;
> a recommended arrangement calculating unit for calculating a recommended arrangement of the image forming device in the predetermined area in accordance with a positional relation between the route of each user obtained by the route obtaining unit and a position in which the image forming device is installed; and
> a display unit for displaying the recommended arrangement calculated by the recommended arrangement calculating unit.

In the present invention, the recommended arrangement of the image forming device in the predetermined area in which the image forming device is installed, is calculated in accordance with the route of each user in the predetermined area and is displayed. For example, the recommended arrangement of the image forming device is calculated so as to become close to the route of each user, and is displayed. Thereby, it is possible to recommend (propose) the arrangement in which even though each user stops by the image forming device during the user's movement, the excess movement is suppressed. In view of the recommended arrangement, the administrator or the like can install the image forming device at a convenience place in which even though each user stops by the image forming device during the user's movement, the inconvenience caused to each user is reduced.

Preferably, with respect to the user having a plurality of routes, each of the plurality of the routes is weighted in accordance with a route usage frequency of each of the plurality of routes.

In the present invention, with respect to the user having a plurality of the routes, the route usage frequency of each of the plurality of routes is considered. Each of the plurality of the routes is weighted in accordance with the route usage frequency of each of the plurality of routes. Then, the recommended arrangement of the image forming device in the predetermined area is calculated in accordance with the weighted route.

Thereby, it is possible to recommend the arrangement of the image forming device so as to become closer to the route having the high route usage frequency than the route having the low route usage frequency. By adopting the recommended arrangement, the inconvenience (the excess movement) caused to the user having a plurality of routes by stopping by the image forming device during the user's movement, is more suppressed. It is possible to improve the efficiency of the work for using the image forming device.

Preferably, the layout support device further comprises an image forming device usage frequency obtaining unit for obtaining an image forming device usage frequency of each user,
wherein the recommended arrangement calculating unit calculates the recommended arrangement by weighting each user in accordance with the image forming device usage frequency of each user.

In the present invention, the difference in the image forming device usage frequency between the users is considered. The recommended arrangement of the image forming device in the predetermined area is calculated in accordance with the route of each user and the image forming device usage frequency of each user, and is displayed. Thereby, it is possible to propose the arrangement of the image forming device so as to become closer to the route of the user having the high image forming device usage frequency than the route of the user having the low image forming device usage frequency.

By adopting the recommended arrangement, the inconvenience (the excess movement) caused to the user having the high image forming device usage frequency by stopping by the image forming device during the user's movement, is more suppressed. It is possible to improve the efficiency of the work for using the image forming device. Further, it is possible to equalize the inconvenience between the users, which is caused by stopping by the image forming device during the user's movement. The efficiency of stopping by the image forming device for all of the users, that is, the efficiency of the office work of all of the users sharing the image forming device can be more improved.

Preferably, the layout support device further comprises an installable place information obtaining unit for obtaining information indicating a plurality of installable places in which the image forming device is installable in the predetermined area,
wherein the recommended arrangement calculating unit evaluates each of the plurality of installable places in accordance with an increased distance caused by stopping by the installable place while the user uses the route, and calculates the recommended arrangement by selecting an optimum installation place as the recommended arrangement among the plurality of installable places.

In the present invention, each of a plurality of installable places in which the image forming device can be installed is evaluated in accordance with the increased distance caused by stopping by the installable place while the user uses the route (the route of each user). For example, the installable place in which the increased distance is short is highly evaluated and the installable place in which the increased distance is long is low evaluated. By evaluating a plurality of installable places, the optimum installation place is calculated and displayed as the recommended arrangement. Thereby, the administrator or the like can easily grasp the optimum installation place of the image forming device in the predetermined area.

Preferably, the increased distance is a shortest distance between the route and the installable place.

In the present invention, by approximating the increased distance so as to regard the increased distance as the shortest distance between the route and the installable place, it is possible to calculate the reasonable increased distance by a simple process (operation).

Preferably, when the recommended arrangement calculating unit evaluates each of the plurality of installable places, the recommended arrangement calculating unit considers at least one of an achievement rate of a ratio between the increased distances calculated for the respective users to a target ratio, and a sum of the increased distances calculated for respective users.

In the present invention, in case that the installable places are evaluated in consideration of the achievement rate of the ratio between the increased distances calculated for the respective users to the target ratio, for example, the installable place having the high achievement rate is highly evaluated and the installable place having the low achievement rate is low evaluated. In case that the installable places are evaluated in consideration of the sum of the increased distances calculated for the respective users, for example, the installable place in which the sum of the increased distances is small is highly evaluated and the installable place in which the sum of the increased distances is large is low evaluated. In case that both of the achievement rate and the sum of the increased distances are considered, for example, the installable place in which the ratio between the increased distances of the respective users approximates the target ratio (the achievement ratio is high) and the sum of the increased distances is small (the installable place is near the routes of the respective users), is highly evaluated.

By evaluating the installable places under the above conditions in accordance with the increased distances, it is possible to calculate more suitable optimum installation place (recommended arrangement).

Preferably, with respect to the user having a plurality of routes, the recommended arrangement calculating unit calculates a representative increased distance which is the increased distance that is representative for the plurality of routes, and evaluates each of the plurality of installable places by using the representative increased distance.

In the present invention, with respect to the user having a plurality of routes, by the above evaluation carried out by using the representative increased distance which is the increased distance that is representative for the above plurality of routes, it is possible to suitably carry out the above evaluation for the user (a plurality of routes of the user). As the representative increased distance, the increased distance of one route selected from a plurality of routes as a representative may be adopted. The representative value which is calculated from each increased distance of a plurality of routes may be used as the representative increased distance. The representative value includes the average value, the median value (median), the mode or the like of the increased distances.

Preferably, the display unit displays the calculated recommended arrangement of the image forming device on a layout map.

In the present invention, by displaying the recommended arrangement of the image forming device on the layout map, it is possible to display the recommended arrangement of the image forming device so as to instantly understand the arrangement.

Preferably, the route obtaining unit obtains user's seat position information indicating a seat position of each user in the predetermined area, predetermined position information indicating a predetermined position in the predetermined area and user passing information indicating a user whose passing through the predetermined position is detected, and

the route obtaining unit recognizes a route obtained by connecting the seat position of the user indicated in the user passing information with the predetermined position, as the route of the user.

In the present invention, with respect to the user whose passing through the predetermined position in the predetermined area is detected, the route obtained by connecting the seat position of the user with the predetermined position is recognized (estimated) as the route. By such a detection of the passing through the predetermined position, it is possible to simply calculate the route of the user.

Preferably, the predetermined position is an entrance for entering or exiting the predetermined area.

In the present invention, in case that each user stops by the image forming device while the user enters and exits the predetermined area and moves, it is possible to recommend (propose) the arrangement of the image forming device so as to suppress the excess movement of each user.

According to the present invention, it is possible to propose the arrangement of the image forming device in which the user easily stops by the image forming device during the user's movement. Thereby, it is possible to install the image forming device at a place in which the users sharing the image forming device easily stop by the image forming device during the movements. It is possible to improve the efficiency of the office work of all of the users sharing the image forming device.

BRIEF DESCRIPTION OF THE DRAWINGS

The present invention will become more fully understood from the detailed description given hereinafter and the accompanying drawings given by way of illustration only, and thus are not intended as a definition of the limits of the present invention, and wherein:

FIG. 1 is a configuration diagram of a system according to the first embodiment;
FIG. 2 is a block diagram showing a schematic configuration of a user terminal according to the first embodiment;
FIG. 3 is a view showing an example of a print window displayed in a display unit of the user terminal;
FIG. 4 is a view showing an example of a printer property window displayed in a display unit of the user terminal;
FIG. 5 is a block diagram showing a schematic configuration of a multi function peripheral (MFP) as an image forming device according to the first embodiment;
FIG. 6 is a block diagram showing a schematic configuration of an information collecting terminal as a layout support device according to the first embodiment;
FIG. 7 is a view showing an example of a layout of an office in which the user terminals and the image forming device are arranged;
FIG. 8 is a view showing an example of a layout map of the office, which is prepared by the information collecting terminal;
FIG. 9 is a view showing an example of a layout map in which the recommended installation place of the image forming device is displayed;
FIG. 10 is a view showing an example of a layout map in which the recommended installation place of each image forming device is displayed in case that another image forming device is additionally installed;
FIG. 11 is a view showing an example of a layout map in which the recommended installation place calculated by weighting each user in accordance with the image forming device usage frequency of each user is displayed;
FIG. 12 is a view showing an example of the user's route in which the user is required to detour in case that the user stops by the image forming device while the user moves from the user's seat in the office to a conference room;

FIG. 13 is a view showing an example of the user's route in which the user is not required to detour in case that the user stops by the image forming device while the user moves from the user's seat in the office to a conference room;

FIG. 14 is a flowchart showing the operation relating to the print instruction for printing a document, which is carried out by the user terminal;

FIG. 15 is a flowchart showing the operation of the printer driver of the user terminal;

FIG. 16 is a flowchart showing the print operation for printing a print file received from the user terminal, which is carried out by the image forming device;

FIG. 17 is a flowchart showing the operation for proposing the recommended arrangement of the image forming device, which is carried out by the information collecting terminal;

FIG. 18 is a flowchart showing the detail operation in the steps S405 and S406 of FIG. 17;

FIG. 19 is a view showing an example of the table entering the image forming device usage frequency of each user terminal, the ratio of each image forming device usage frequency and the ratio of the distance;

FIG. 20 is a view showing an example of the layout map in which the recommended installation place calculated in consideration of the route usage frequency of each route is displayed according to a second embodiment;

FIG. 21 is a view showing an example of the configuration for estimating the route of each user according to the third embodiment; and

FIG. 22 is a view showing an example in which the route except the entering into the office room and the exiting from the office room can be estimated by the configuration shown in FIG. 21.

DETAILED DESCRIPTION OF PREFERRED EMBODIMENT

Hereinafter, the preferred embodiments will be explained with reference to the accompanying drawings.

[First Embodiment]

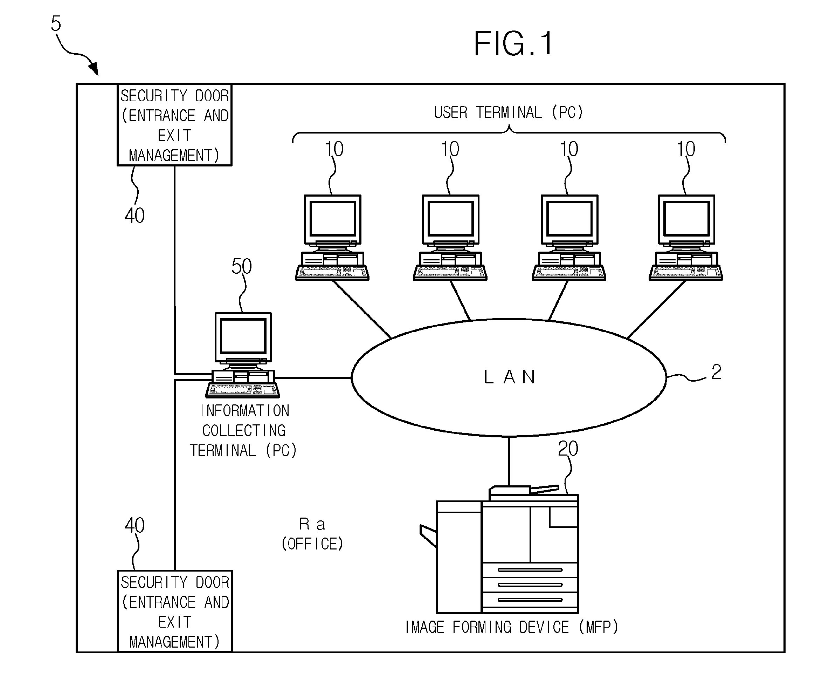

FIG. 1 shows the configuration of a system 5 according to the first embodiment. The system 5 is configured so as to connect a plurality of user terminals 10, an image forming device 20 and an information collecting terminal 50 as a layout support device via a network 2 such as an LAN (Local Area Network) and the like, which is provided in an office Ra. Further, in the system 5, a plurality of security doors 40 having an entrance and exit management function of the office Ra is connected with the information collecting terminal 50.

In the embodiment, the image forming device 20 is a multi function peripheral (MFP) having multiple functions, such as a copy function, a scan function, a printer function, a facsimile function, a post-processing function and the like.

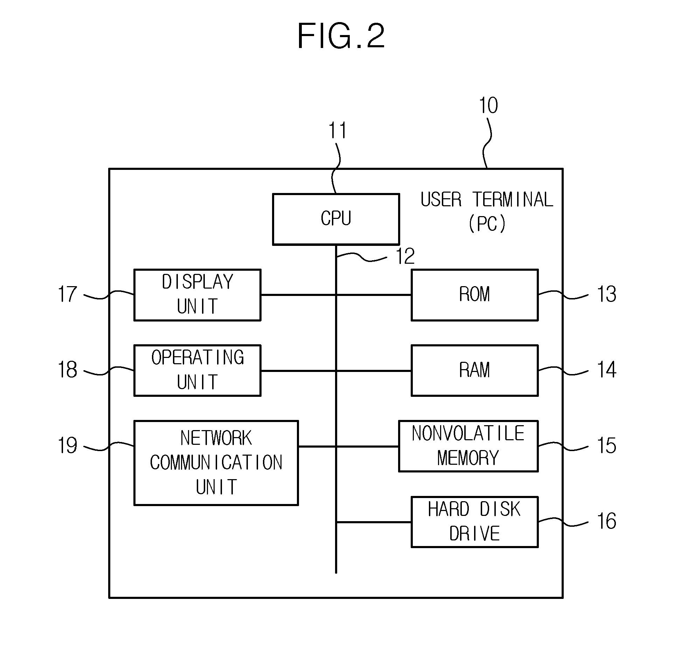

FIG. 2 shows a schematic configuration of the user terminal 10. The user terminal 10 has a function for instructing the image forming device 20 to execute jobs, such as a scan job, a print job or the like, by sending the jobs to the image forming device 20. The user terminal 10 is a personal computer (PC) or the like, in which an OS program, a driver program for the image forming device 20, various types of application programs for preparing and editing a document and/or an image and the like are installed. By the driver program, the image forming device 20 is requested to execute various types of commands, for example, a print job is entered to the image forming device 20.

The user terminal 10 is configured so as to connect a CPU (Central Processing Unit) 11 with a ROM (Read Only Memory) 13, a RAM (Random Access Memory) 14, a nonvolatile memory 15, a hard disk drive 16, a display unit 17, an operating unit 18, a network communication unit 19 and the like via a bus 12.

The CPU 11 controls the operation of the user terminal 10 in accordance with the program stored in the ROM 13. Further, the CPU 11 executes various processes in accordance with the programs stored in the hard disk drive 16. In the ROM 13, a start-up program, fixed data and the like are stored. In the RAM 14, the program read out from the hard disk drive 16 is stored. Further, the RAM 14 is used as a work memory for temporarily storing various data when the CPU 11 executes the program.

The nonvolatile memory 15 is a rewritable memory in which the stored data is held even when the power source is off. In the nonvolatile memory 15, system information of the user terminal 10 (such as the terminal information (terminal ID (Identification)), IP (Internet Protocol) address or the like), user information (user ID), various types of setting information and the like are stored. The hard disk drive 16 is a large-capacity nonvolatile memory device. In the hard disk drive 16, an OS program, a driver program for the image forming device 20, various types of application programs, files, data and the like are stored.

The display unit 17 is configured by a display device, such as a liquid crystal display or the like. The operating unit 18 is configured by an operating input device, such as a keyboard, a mouse or the like.

The network communication unit 19 communicates with the image forming device 20, the information collecting terminal 50 and the like via the network 2, to send and receive various data.

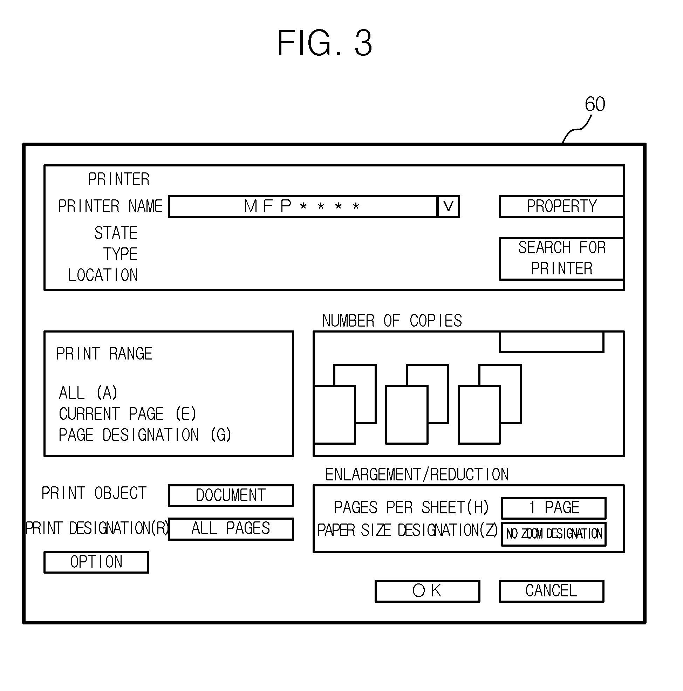

FIG. 3 shows an example of a print window 60 displayed in the display unit 17 of the user terminal 10. In the user terminal 10, an application program for printing a document (file) is started by user's operation. When the "print" menu is opened (not shown in the drawings), the print window 60 is displayed in the display unit 17. The user can designate a printer for printing a document to be printed (sending destination of a print job) and can instruct the designated printer to execute the print of the document via the print window 60. For example, the printer is designated by selecting an image forming device (for example, the image forming device 20) as a printer to be used in a "printer name" of a "printer" area shown in the print window 60. The instruction for executing the print is carried out by clicking an "OK" button shown in the print window 60.

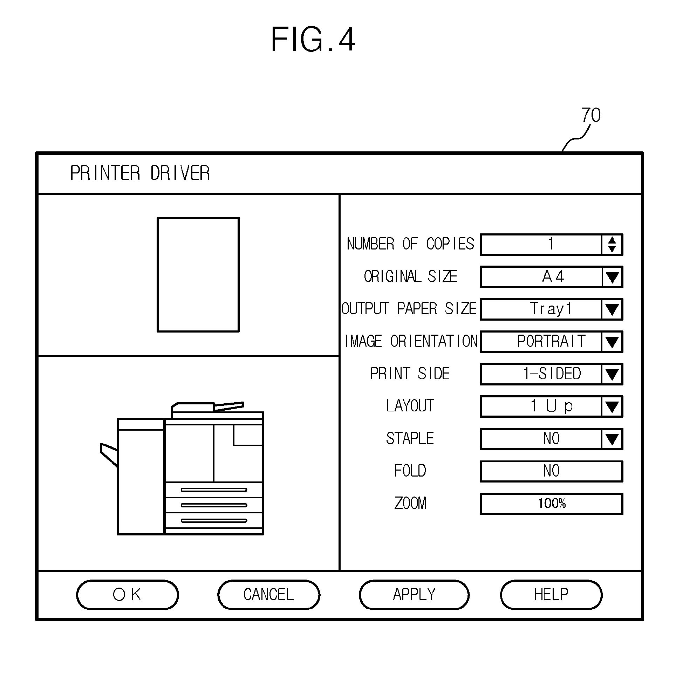

When a "property" button shown in the upper side of the print window 60 is clicked in state that the image forming device 20 is designated as the printer to be used, the user terminal 10 displays a printer property window 70 shown in FIG. 4 in the display unit 17. The user can set the property relating to the print of the document to be printed via the printer property window 70.

In case that the printer to be used is the image forming device 20, as shown in the printer property window 70, the setting items (parameters), such as the number of copies of the document, original size (A4 or the like), output paper size (tray number or the like), the orientation of the image in the paper (portrait/landscape), print side (1-sided/2-sided), layout (NUp), staple (No/Yes), fold (No/Yes), zoom (N%), and the like, are displayed. The user can set the appropriate parameters to the setting items. The setting is determined by clicking "OK" button (or "APPLY" button) displayed in the printer property window 70.

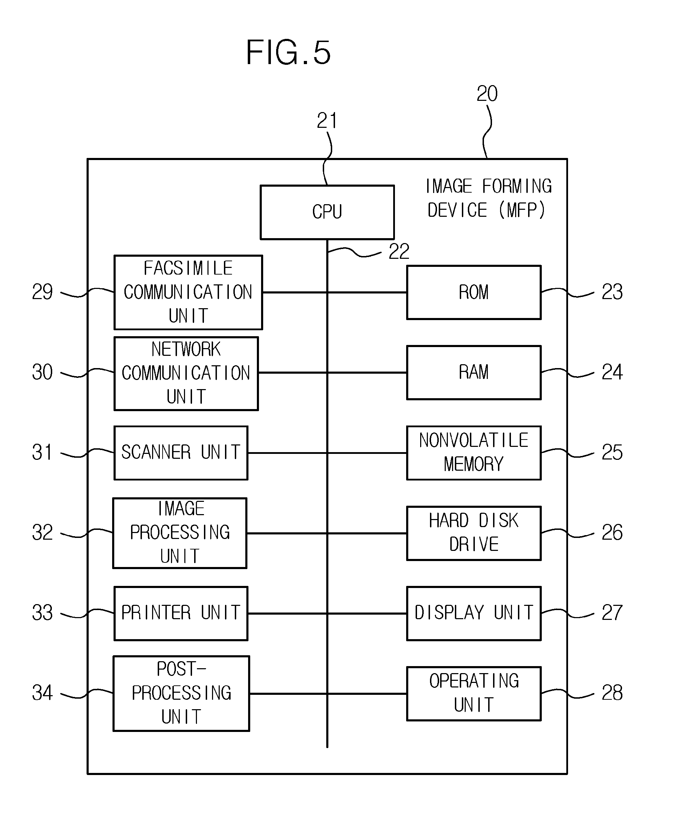

FIG. 5 shows the schematic configuration of the image forming device 20. The image forming device 20 has a copy function for optically reading an image of an original and printing the read image on a recoding paper, a scan function for scanning an original to store image data of the original as a file or to transmit the image data to an external device, a printer function for printing out an image based on image data received from the user terminal 10 or an image based on image data stored in the image forming device 20 on recording paper, a facsimile function, a post-processing function, such as the staple and the fold, and the like.

The image forming device 20 is configured so as to connect a CPU 21 for controlling the overall operations of the image forming device 20, with a ROM 23, a RAM 24, a nonvolatile memory 25, a hard disk drive 26, a display unit 27, an operating unit 28, a facsimile communication unit 29, a network communication unit 30, a scanner unit 31, an image processing unit 32, a printer unit 33 and a post-processing unit 34 via a bus 21.

By the CPU 21, a middleware, application programs and the like are executed on an OS program as a base. In the ROM 23, various types of programs are stored. The CPU 21 realizes each function of the image forming device 20, such as the execution of a job, by executing the processes in accordance with these programs. The RAM 24 is used as a work memory for temporarily storing various data when the CPU 21 executes the programs and as an image memory for storing image data. The other necessary programs are loaded from the hard disk drive 26 to the RAM 24 and are executed.

The nonvolatile memory 25 is a rewritable memory (flash memory) in which the stored data is held even when the power source is off. In the nonvolatile memory 25, the unique information of the image forming device 20 (IP address or the like), various types of setting information and the like are stored. The hard disk drive 26 is a large-capacity nonvolatile memory device, and is used in order to store programs and other data, such as print data, image data, job record data and the like.

An operating panel of the image forming device 20 comprises the display unit 27 and the operating unit 28. The display unit 27 is configured by a liquid crystal display or the like, and displays various screens, such as an initial screen, an operation screen, a setting screen and the like. The operating unit 28 receives various operations from the user, such as the input and setting of a job, and the like. The operating unit 28 comprises a touch panel which is provided on the screen of the display unit 27. The touch panel detects a coordinate position in which the user pushes down. Further, the operating unit 28 comprises a numerical keypad, an alphabetical keypad, a start key and the like.

The facsimile communication unit 29 transmits image data to an external device having a facsimile function and receives image data from the external device via a public line. The network communication unit 30 communicates with the user terminal 10, the information collecting terminal 50 and the like via the network 2.

The scanner unit 31 obtains image data by optically reading an image of an original. The scanner unit 31 comprises a light source for irradiating the original with light, a line image sensor for reading the original line by line in the width direction of the original by receiving the reflected light from the original, a moving unit for sequentially moving the reading position line by line in the longitudinal direction of the original, an optical system having lenses, mirrors and the like for guiding the reflected light from the original to the line image sensor and focusing the reflected light on the line image sensor, a converting unit for converting an analog image signal outputted from the line image sensor into digital image data, and the like.

The image processing unit 32 carries out various image processings, such as the rasterization processing for converting print data into image data, image compensation, rotation, enlargement/reduction, compression/decompression of image data, and the like.

The printer unit 33 forms an image based on image data, on recording paper by the electrophotographic process, and outputs the recording paper. For example, the printer unit 33 is configured as the so-called laser printer comprising a conveying device for the recording paper, a photoconductive drum, a charging device, an LD (Laser Diode) of which the lighting is controlled in accordance with the input image data, a scanning unit for scanning the photoconductive drum by the laser light outputted from the LD, a developing device, a transfer and separation device, a cleaning device and a fixing device. Another type of printer, such as an LED (Light Emitting Diode) printer which irradiates the photoconductive drum with an LED head instead of laser light, may be used.

The post-processing unit 34 carries out post-processings (finishing processes), such as staple, punch, fold, booklet, insert sheet and the like, for the recoding paper on which the image is printed out from the printer unit 33.

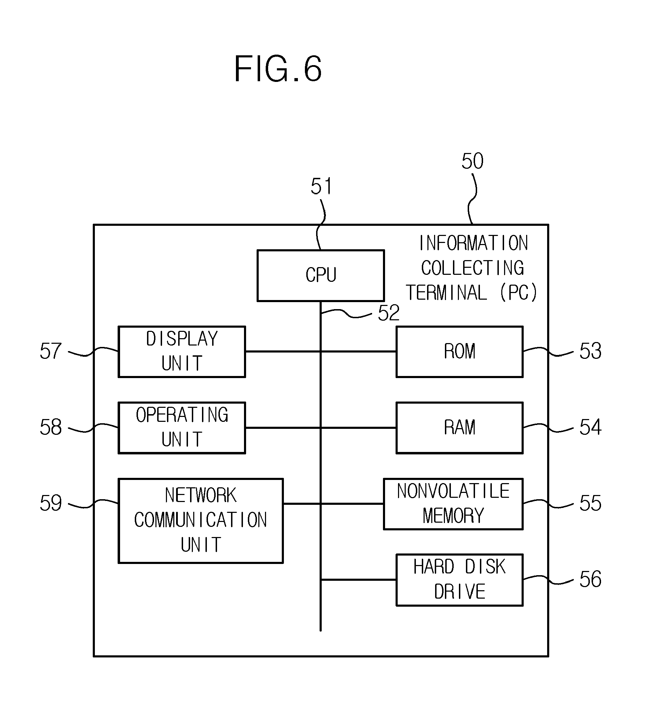

FIG. 6 shows the schematic configuration of the information collecting terminal 50. The information collecting terminal 50 is a personal computer (PC) or the like, similarly to the user terminal 10.

The information collecting terminal 50 has a function for obtaining the routes of each user in an office Ra, who uses the image forming device 20 installed in the office Ra, and for calculating and displaying the recommended arrangement (recommended installation place) of the image forming device 20 in the office Ra. For example, in case that the image forming device 20 is installed near the routes which the users ordinarily use, these users easily stop by the image forming device 20 during their movements to various destinations. As a result, the convenience and the efficiency of the office work are improved. The information collecting terminal 50 calculates and proposes the proper arrangement of the image forming device 20 relative to the route(s) of each user.

Further, the recommended arrangement is calculated by weighting each user in accordance with the image forming device usage frequency of each user in consideration of the difference in the image forming device usage frequency between the users. With respect to the user having a plurality of routes, the route usage frequency of each of the plurality of routes is considered. Each of the plurality of the routes is weighted in accordance with the route usage frequency of each of the plurality of routes. Then, the recommended arrangement is calculated based on the weighted routes. When the recommended arrangement is calculated, only one of the image forming device usage frequency and the route usage frequency may be considered, or both of them may be considered.

The usage frequency of the image forming device 20 is obtained by collecting the job record from the image forming device 20 and by counting the usage record of the image forming device 20 (the number of jobs) for each user. In addition to the above collection of job record from the image forming device 20, the job record may be collected by receiving the job transmitted via the network 2. Further, the record of the jobs transmitted to the image forming device 20 may be collected from each user terminal 10. The route usage frequency of each route of the user having a plurality of routes, is obtained by collecting the passing record of the user, in which the user passes through each security door 40 and by calculating the usage frequency (the number of passing) of each security door 40. The obtaining of the route usage frequency will be explained later in detail.

The administrator (or the user) previously sets the period for collecting the job record from the image forming device 20 and the period for collecting the above passing record of the user to the image collecting terminal 50. These periods can be optionally set, such as the period (whole period) from the installation of the image forming device 20 to the present, the past year, the past month or the like.

The information collecting terminal 50 is configured so as to connect a CPU 51 with a ROM 53, a RAM 54, a nonvolatile memory 55, a hard disk drive 56, a display unit 57, an operating unit 58, a network communication unit 59 and the like via a bus 52.

The CPU 51 controls the operation of the information collecting terminal 50 in accordance with the program stored in the ROM 53. Further, the CPU 51 executes various processes in accordance with the programs stored in the hard disk drive 56. In the ROM 53, a start-up program, fixed data and the like are stored. In the RAM 54, the program read out from the hard disk drive 56 is stored. Further, the RAM 54 is used as a work memory for temporarily storing various data when the CPU 51 executes the program.

The nonvolatile memory 55 is a rewritable memory in which the stored data is held even when the power source is off. In the nonvolatile memory 55, system information of the information collecting terminal 50 (such as the terminal information (terminal ID), IP address or the like), various types of setting information, tables and the like are stored. The hard disk drive 56 is a large-capacity nonvolatile memory device. In the hard disk drive 56, an OS program, a driver program for the image forming device 20, various types of application programs, files, data and the like are stored.

The display unit 57 is configured by a display device, such as a liquid crystal display or the like. The operating unit 58 is configured by an operating input device, such as a keyboard, a mouse or the like.

The network communication unit 59 communicates with the image forming device 20, the user terminals 10 and the like via the network 2, to send and receive various data. Further, the network communication unit 59 communicates with the security doors 40.

Next, the system 5 according to the present embodiment will be explained.

The proposal of the recommended arrangement of the image forming device 20, which is carried out by the information collecting terminal 50 is schematically explained.

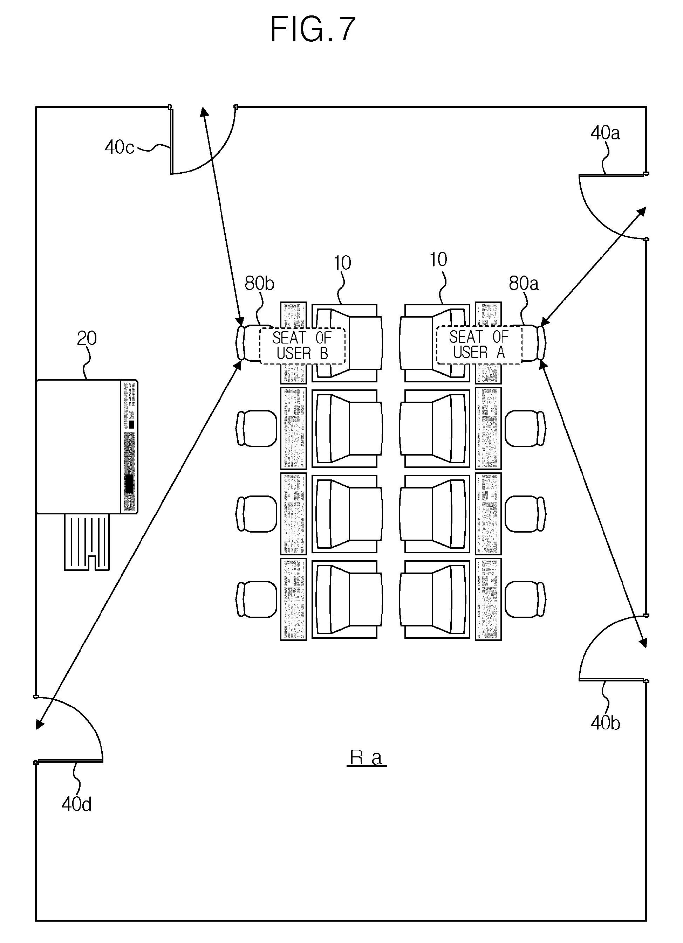

FIG. 7 shows an example of a layout in the office Ra. The office Ra has a rectangular shape viewed from above. In the office Ra, four entrances are provided at the upper right position, the lower right position, the upper left position and the lower left position of this drawing, respectively. Further, security doors 40 are provided on the entrances, respectively. Hereinafter, among the security doors 40 provided on the entrances, the numeral reference 40a denotes the security door provided at the upper right position of the office Ra. Similarly, the numeral reference 40b denotes the security door provided at the lower right position, 40c denotes the security door provided at the upper left position, and 40d denotes the security door provided at the lower left position.

A seat group for a plurality of users (office workers) who work in the office Ra is arranged almost in the center of the office Ra. In the example, seats (desk and chair) of users are arranged in two rows in a longitudinal direction of FIG. 7. On each seat, the user terminal 10 is provided. The information collecting terminal 50 may be provided on any one seat of the seat group, or may be provided at another position except the seat group. For example, the information collecting terminal 50 can be provided on a seat of the administrator, on a special or common table or the like. In this example, the seat of the user A is arranged at the uppermost position in the right row of the seat group as shown in FIG. 7. The seat of the user B is arranged at the uppermost position in the left row of the seat group as shown in FIG. 7.

In this example, the image forming device 20 is installed near the wall on the left side of the office Ra and near the middle position between the security doors 40c and 40d.

In the office Ra having the above layout, for example, in case that the user A enters and exits the office Ra through the security door 40a or the security door 40b and the user B enters and exits the office Ra through the security door 40c or the security door 40d, it is to be said that the image forming device 20 is installed near the routes of the user B to the security doors 40c and 40d, but apart from the routes of the user A to the security doors 40a and 40b. In this case, the user B hardly detours even when the user B stops by the image forming device 20 during the movements for entering and exiting the office Ra through the security doors 40c and 40d. On the other hand, the user A detours when the user A stops by the image forming device 20 during the movements for entering and exiting the office Ra through the security doors 40a and 40b. Therefore, the above arrangement of the image forming device 20 is inconvenient for the user A.

The cases that the user stops by the image forming device 20 during the movement for exiting the office Ra include the followings. As the first example of the above cases, when the user moves to a conference room from the user's seat, the user instructs the image forming device 20 via the user terminal 10 to print the handouts or the like for the meeting, stops by the image forming device 20 to obtain the handouts and then directly moves to the conference room. As the second example, the user copies the handouts or the like by using the image forming device 20 to obtain the copied handouts and directly goes to the conference room. As the third example, the user obtains the printed document by the facsimile reception carried out by the image forming device 20 and moves out of the office Ra (moves to another office, the conference room or the like). As the fourth example, after the user stops by the image forming device 20 to carry out the facsimile transmission, the user moves out of the office Ra. Further, the cases that the user stops by the image forming device 20 during the movement to the user's seat after entering the office Ra include the followings. As the first example of the above cases, after the user enters the office Ra, the user stops by the image forming device 20 to copy the handouts held in the user's hand and then returns to the user's seat. As the second example, after the user enters the office Ra, the user stops by the image forming device 20 to confirm whether the printed document to himself/herself is obtained by the facsimile reception carried out by the image forming device 20 and then the user collects the print document when the print document is obtained and returns to the user's seat.

The information collecting terminal 50 proposes the arrangement of the image forming device 20 in accordance with the route of each user in the office Ra so that each user easily stops by the image forming device 20 during the movement of each user and so that the convenience and the efficiency of the office work are improved.

In this example, the information collecting terminal 50 previously obtains various types of information for preparing a layout map (floor layout diagram) of the office Ra and stores the information in the hard disk drive 56. The above information for preparing the layout map may be stored in the nonvolatile memory 55.

The above various types of information include the floor information indicating the shape (or the size) of the planer view of the floor in the office Ra, the positions and the sizes of the entrances (security doors 40) and the like, the seat information indicating the position and the shape (or the size) of the planer view of each user's seat arranged in the office Ra, the installation place information indicating the position and the shape (or the size) of the planer view of the image forming device 20 installed in the office Ra.

With respect to the position of the entrance, the middle position in the width direction of the entrance may be treated as the representative coordinate of the entrance. With respect to the position of the user's seat, the position in which the chair is arranged may be treated as the representative coordinate of the seat. With respect to the position of the image forming device 20, the middle position in the width direction of the front surface of the image forming device 20 may be treated as the representative coordinate of the image forming device 20.

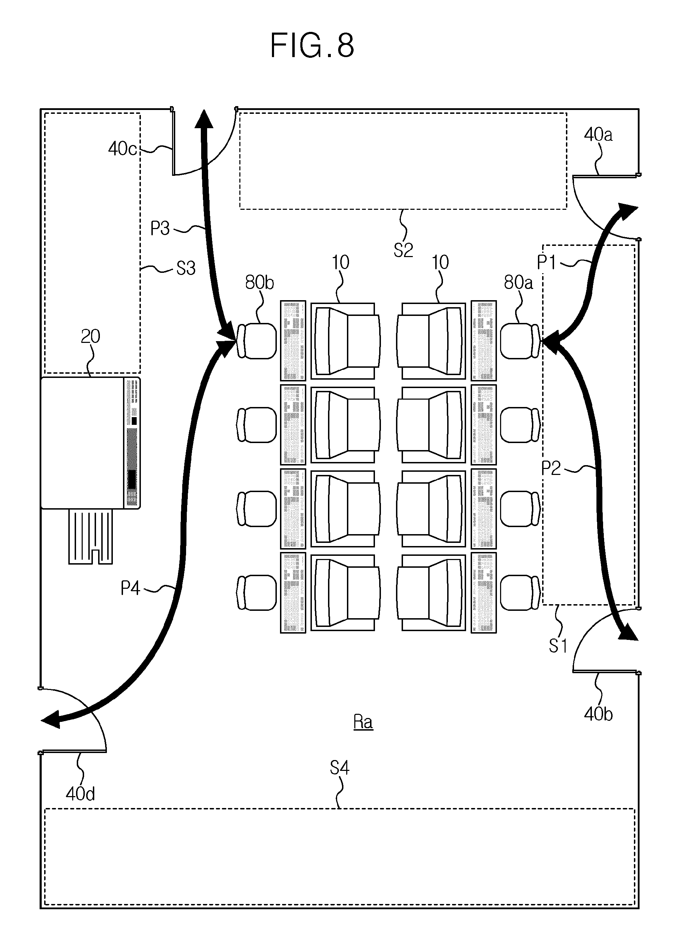

The administrator (or the user) may previously input the above various types of information to the information collecting terminal 50. The information collecting terminal 50 may obtain the above information from a server device in which the above various types of information are stored. The information collecting terminal 50 prepares the layout map of the office Ra shown in FIG. 8 by using the above various types of information stored in the hard disk drive 56 (or the nonvolatile memory 55).

On the other hand, for example, the entrance and exit management for the users which belong to the office Ra is carried out as follows.

Each user carries an ID card in which one's own user ID is stored. The ID card is a noncontact IC (Integrated Circuit) card or the like. In the security doors 40, a communication unit (noncontact communication unit) for carrying out the noncontact communication with the user's ID card is provided.

The security doors 40 normally cannot open from the outside of the office Ra by locking the security doors 40. When the user enters the office Ra, the communication unit of the security door 40 carries out the noncontact communication with the ID card which the user carries, and obtains the user ID. The user authentication is carried out by using the obtained user ID. When the user is authenticated, the security door 40 is unlocked and can open. On the other hand, the security doors 40 can always open from the inside of the office Ra.
Alternatively, similarly to the open of the security doors 20 from the outside of the office Ra, the security doors 40 can open from the inside of the office Ra when the user authentication is carried out by the noncontact communication with the ID card.

Each security door 40 detects the user passing through the entrance in which the security door 40 is provided, by the above user authentication, and inputs the detected user information (user ID) as the passing record information of the user to the information collecting terminal 50.

The information collecting terminal 50 estimates (recognizes) the route of each user in the office Ra in accordance with the passing record information inputted from the security door 40, the position information of the entrance (security door 40) and the seat information of each user, which are included in the floor information.

The route (traffic line) is calculated, for example, by connecting the position of the user' s seat and the position of the entrance (security door 40) with a straight line. When an obstacle exists on the above straight line, the route is calculated by connecting the above two positions with a plurality of lines constituting the shortest length so as to avoid the obstacle. Alternatively, the route is calculated by connecting the above two positions with a suitable curved line which is calculated by a predetermined function. When an obstacle exists on the above curved line, the route is calculated by connecting the above two positions with a suitable curved line having the shortest length so as to avoid the obstacle.

As described above, when the user A enters and exits the office Ra through the security door 40a or 40b, the security door 40a or 40b detects the passing of the user A to input the passing record information of the user A to the information collecting terminal 50. When the user B enters and exits the office Ra through the security door 40c or 40d, the security door 40c or 40d detects the passing of the user B to input the passing record information of the user B to the information collecting terminal 50.

The information collecting terminal 50 identifies the user shown by the above passing record information (user ID), and estimates the line from the user' s seat to the security door 40 which inputs the passing record information to the information collecting terminal 50, as the route. When a plurality of security doors 40 input the passing record information of the same user to the information collecting terminal 50, the information collecting terminal 50 recognizes that the above user has a plurality of routes. The information collecting terminal 50 estimates the lines from the user' s seat to each of the security doors 40 which input the passing record information of the same user to the information collecting terminal 50, as the separate routes.

In this example, with respect to the user A, the information collecting terminal 50 estimates the route P1 between the seat 80a of the user A and the security door 40a, and the route P2 between the seat 80a of the user A and the security door 40b. With respect to the user B, the information collecting terminal 50 estimates the route P3 between the seat 80b of the user B and the security door 40c, and the route P4 between the seat 80b of the user B and the security door 40d. In FIG. 8, each of the estimated routes is shown by each traffic line obtained by connecting the position of the user' s seat and each entrance (security door 40) with a suitable curved line.

The information collecting terminal 50 extracts the installable places in which the image forming device 20 can be installed, from the office Ra, and calculates the distance between the above installable place and each route. In detail, the information collecting terminal 50 calculates the distance between each route and the image forming device 20 in case that the image forming device 20 is installed at the above installable place. The distance is calculated as the increased distance from the route, which is caused by stopping by the above installable place (by stopping by the image forming device 20 which is installed in the installable place) while the route is used. In this embodiment, the increased distance is approximated so as to regard the increased distance as the shortest distance between the installable place and the route.

In this example, the shortest distances between the estimated route P1 of the user A and the installable place and between the estimated route P2 and the installable place, and the shortest distances between the estimated route P3 of the user B and the installable place and between the estimated route P4 and the installable place, are calculated as each increased distance.

The above increased distance is not limited to the shortest distance. For example, the halfway point of the route is treated as a reference point for the distance calculation and the distance between the above halfway point and the image forming device 20 may be used as the increased distance. Further, when the user departs from the route to stop by the image forming device 20, an actual movement distance is calculated by using the layout map (in case that an obstacle exists on the user's route, the shortest movement distance caused by avoiding the obstacle is calculated as the actual movement distance), and the actual increased distance (more precise increased distance) which is calculated by subtracting the distance of the route from the actual movement distance, may be used.

In this example, both the user A and the user B use two routes. With respect to the user having a plurality of routes, the representative value is calculated from each increased distance of a plurality of routes and the representative value is used as the representative increased distance. As the representative value, the average value, the median value (median), the mode or the like of the increased distances, is used.

The information collecting terminal 50 evaluates the installable places by using the above increased distance of each user (by using the representative increased distance in case of the user having a plurality of routes) . In this evaluation, it is determined whether the following two conditions are satisfied or not. One condition is that the sum of the increased distances (the representative increased distances) of the respective users in case of the evaluated installable place is not more than one in case of the current installation place, that is, the evaluated installable place is not more apart from each route than the current installation place. The other condition is that the achievement rate of the ratio between the increased distances (the representative increased distances) of the respective users to a target ratio is not less than the predetermined threshold value. In the result of the evaluation, when the installable place which satisfies the two conditions exists, the information collecting terminal 50 proposes the installable place as a recommended installation place of the image forming device 20.

For example, when the information collecting terminal 50 extracts the installable places from an empty space S1 between the security door 40a and the security door 40b, an empty space S2 between the security door 40a and the security door 40c, an empty space S3 between the security door 40c and the current installation place of the image forming device 20, an empty space S4 between the security door 40b and the security door 40d and the like in the office Ra, the information collecting terminal 50 determines that the installable place in the empty space S2 satisfies the above two conditions. Then, the information collecting terminal 50 displays and proposes the installable place in the empty space S2 as the recommended installation place of the image forming device 20.

For example, the information collecting terminal 50 proposes the recommended installation place of the image forming device 20 by displaying the layout map of the office Ra, in which the image forming device 20 is installed in the empty space (installable place) between the security door 40a and the security door 40c, in the display unit 57.

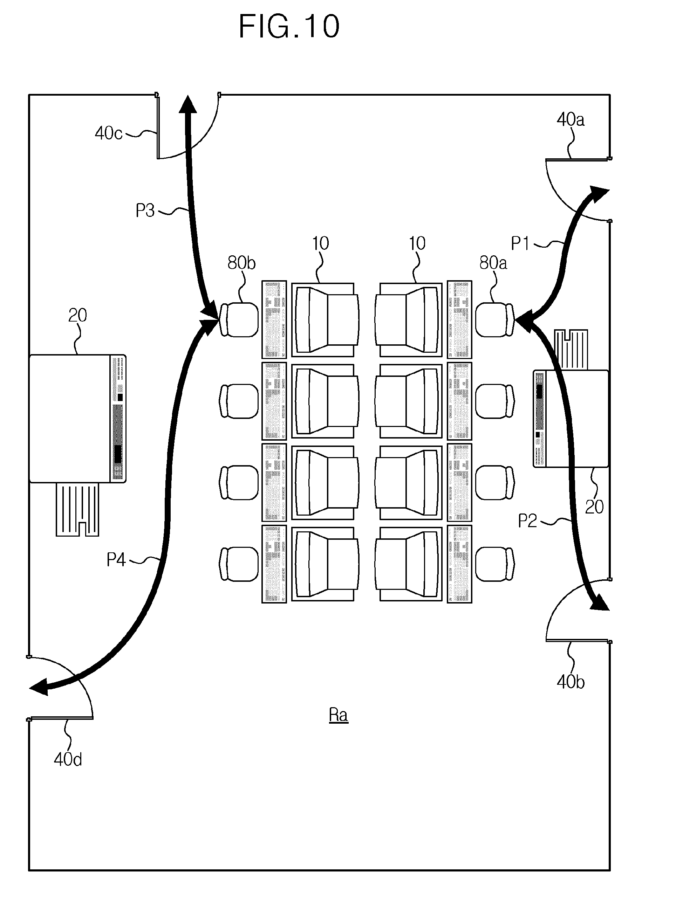

FIG. 10 shows an example of the layout map in which the recommended installation place of each image forming device is displayed in case that another image forming device 20 is additionally installed (added) . Here, the example in which one image forming device 20 is further added and a total of two image forming devices 20 are installed in the office Ra, will be explained.

The information collecting terminal 50 calculates each recommended installation place of two image forming devices 20 to be installed in the office Ra in accordance with the routes of the user A and the user B. In case that two users are considered like this example, the information collecting device 50 calculates two installable places which are the nearest from each route of both users, as each recommended installation place of two image forming devices 20. In case of the addition of the image forming device 20 like this example, the current installation place of the existing image forming device 20 is included in the installable places to be extracted and evaluated.

The information collecting terminal 50 evaluates a plurality of installable places (including the current installation place) which are extracted from the empty spaces in the office Ra, by using the above-described increased distance (in case of the user having a plurality of routes, the representative increased distance) with respect to the routes (P1 and P2) of the user A and the routes (P3 and P4) of the user B. In this evaluation, the information collecting terminal 50 determines that the installable place in which the increased distance (representative increased distance) is the shortest is the recommended installation place (optimum installation place) .

In the above evaluation, with respect to the routes of the user A, the information collecting terminal 50 determines that the installable place extracted from the empty space between the security door 40a and the security door 40b is the recommended installation place. With respect to the routes of the user B, the information collecting terminal 50 determines that the installable place extracted from the empty space between the security door 40c and the security door 40d is the recommended installation place. The existing one image forming device 20 is installed at this recommended installation place between the security door 40c and the security door 40d. With respect to the routes of the user B, the information collecting terminal 50 determines that this current installation place is the recommended installation place.

From the result of the evaluation, as shown in FIG. 10, the information collecting terminal 50 displays the layout map of the office Ra in the display unit 57, in which one image forming device 20 is installed at the current installation place and the other image forming device 20 is installed at the empty space between the security door 40a and the security door 40b, and proposes each recommended installation place of the two image forming devices 20 in case that one image forming device 20 is further installed in addition to the existing image forming device 20.

The number of the image forming device 20 to be additionally installed, is not limited to one. Even when a plurality of image forming devices 20 are additionally installed, the information collecting terminal 50 can propose each recommend installation place. In this case, the number of the image forming device 20 to be additionally installed is suitably set in consideration of the number of the users which belong to the office Ra, each position of the seats, the amount of job throughput, the processing ability of the image forming device 20, and the like.

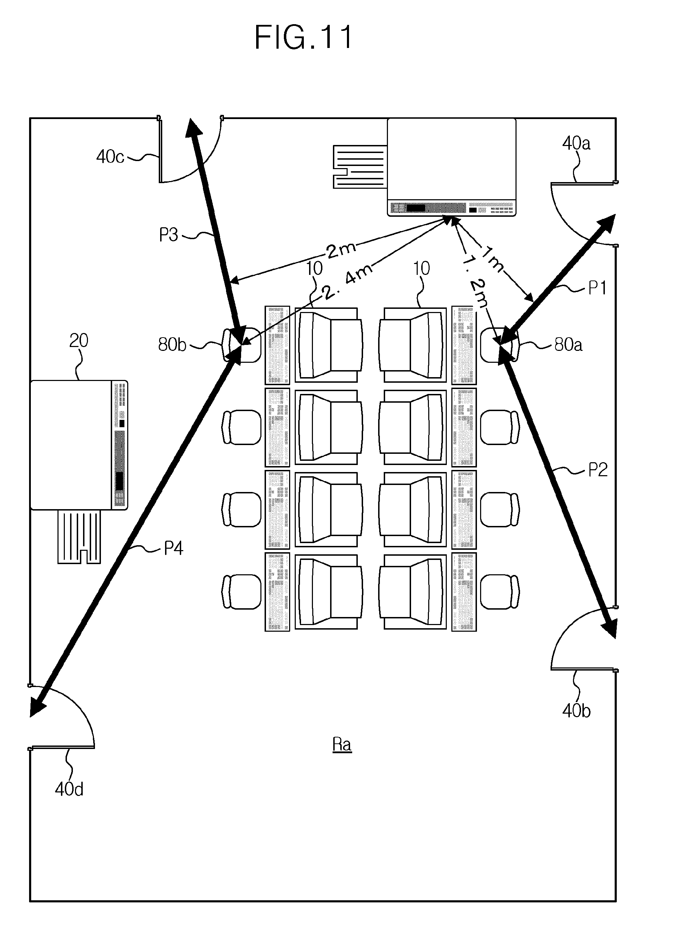

FIG. 11 shows an example of the layout map in which the recommended installation place calculated by weighting each user in accordance with the image forming device usage frequency of each user is displayed. By this layout map, the recommended installation place is proposed so as to install the image forming device 20 closer to the route of the user which uses the image forming device 20 with high frequency than the route of the user which uses the image forming device 20 with low frequency.

Here, the information collecting terminal 50 calculates the reciprocal ratio of the ratio of the number of jobs between the respective users using the image forming device 20. The information collecting terminal 50 uses the above reciprocal ratio as a target ratio, and evaluates each extracted installable place in accordance with the achievement rate of the ratio between the increased distances of the respective users (the representative increased distance in case of the user having a plurality of routes) to the target ratio and the sum of the increased distances (the representative increased distances) of the respective users. Then, from the evaluation, the information collecting terminal 50 calculates the recommended installation place.

For example, when the ratio of the number of jobs between the user A and the user B is 2:1, the information collecting terminal 50 uses 1:2 which is the reciprocal ratio of the above ratio as a target ratio. The information collecting terminal 50 selects the installable places in which the sum of the increased distances (the representative increased distances) of the respective users is not more than one in case of the current installation place, from a plurality of extracted installable places. Further, from the selected installable places, the information collecting terminal 50 determines that the installable place in which the ratio between the increased distance of the user A and the increased distance of the user B is the closest to 1: 2 which is the target ratio (the achievement rate is the highest) is the recommended installation place.

In the layout map of FIG. 11, each route is shown by the straight line connecting between the middle position (the representative coordinate) in the width direction of the entrance (the security door 40) and the position of the user's chair (the representative coordinate of the seat). The increased distance is the shortest distance from the installable place to the route. As a reference point of the installable place, the middle position in the width direction of the front surface of the image forming device 20 in case that the image forming device 20 is installed in the installable place (the representative coordinate), is used. The representative value (the representative increased distance) of the increased distances of a plurality of routes of one user is the average value of the increased distances.

In this example, in case that the ratio of the number of jobs between the user A and the user B is 2:1 and the target ratio is 1:2 which is the reciprocal ratio thereof, the information collecting terminal 50 determines the recommended installation place as follows. The information collecting terminal 50 searches the installable place in which the sum of the representative increased distance of the user A and the representative increased distance of the user B is not more than one in case of the current installation place and in which the ratio between the representative increased distance of the user A and the representative increased distance of the user B is the closest to 1:2. As a result of the search, the searched installable place is the installable place extracted from the empty space between the security door 40a and the security door 40c, in which the representative increased distance of the user A is 1.1m and the representative increased distance of the user B is 2.2m. The information collecting terminal 50 determines that the searched installation place is the recommended installation place.

As shown in FIG. 11, the information collecting terminal 50 displays the layout map of office Ra in the display unit 57, in which the image forming device 20 is installed in the position where the ratio between the representative increased distance of the user A and the representative increased distance of the user B is 1:2, in the empty space between the security door 40a and the security door 40b. Thereby, the information collecting terminal 50 proposes the recommended installation place of the image forming device 20 in consideration of the image forming device usage frequency of each user.

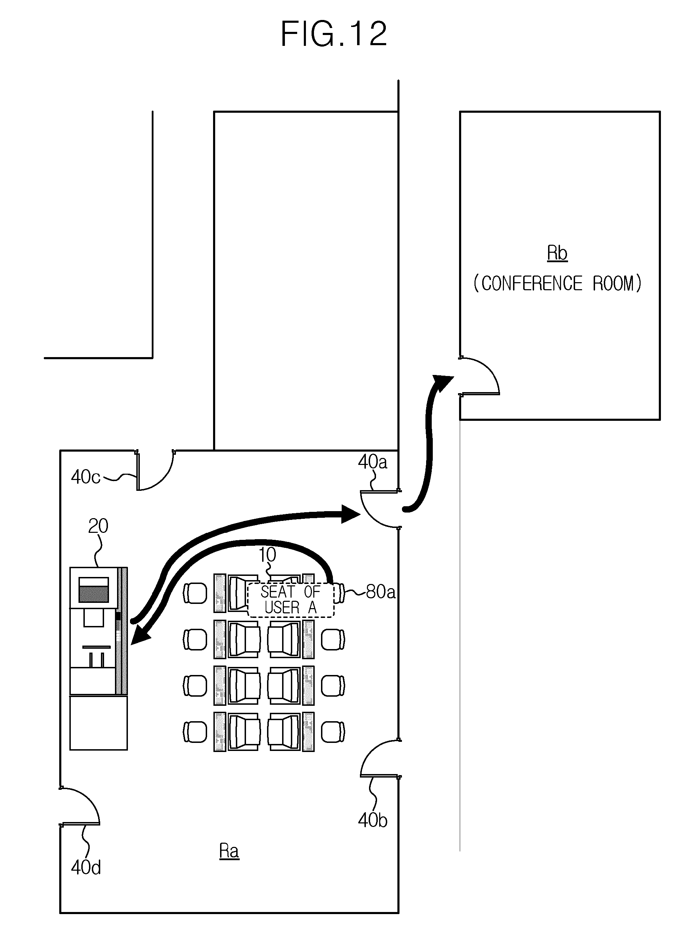

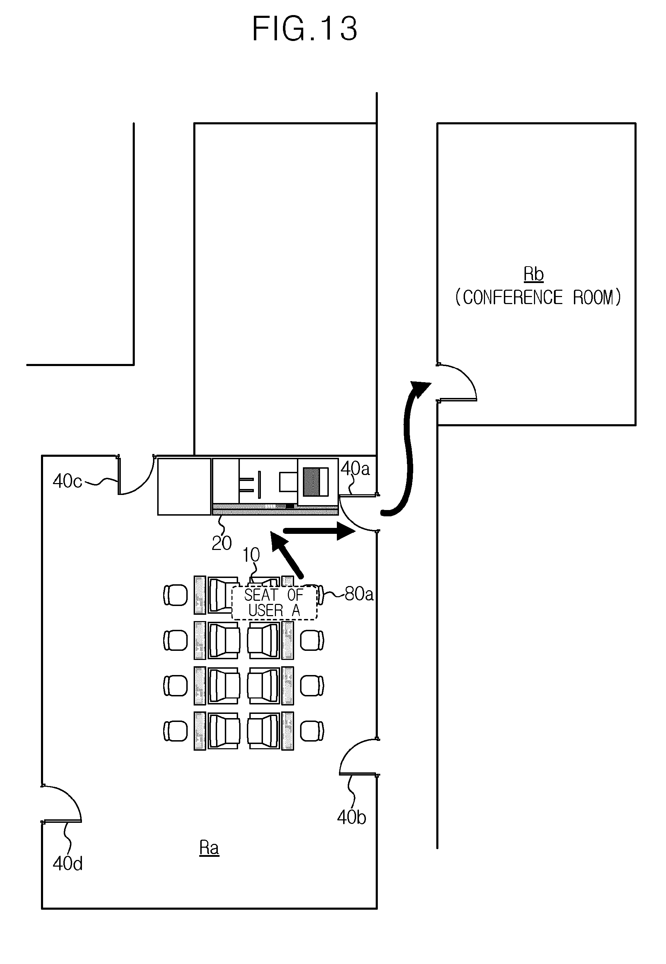

FIG. 12 and FIG. 13 show each route of the user A in which the user A stops by the image forming device 20 while the user A moves from the seat 80a of the user A in the office to a conference room Rb through the security door 40a. Here, for example, the case in which the user A instructs the image forming device 20 via the user terminal 10 of the seat 80a to print the handouts for the meeting, and stops by the image forming device 20 to obtain the printed handouts and then directly moves to the conference room Rb, is assumed.

In FIG. 12, the image forming device 20 is installed between the security door 40c and the security door 40d in the office Ra. In this case, because the user A is required to detour to stop by the image forming device 20 while moving from the seat 80a of the user A to the security door 40a, the movement distance of the user A becomes long. Therefore, the installation place of the image forming device 20, which is shown in FIG. 12 is inconvenient for the user A.

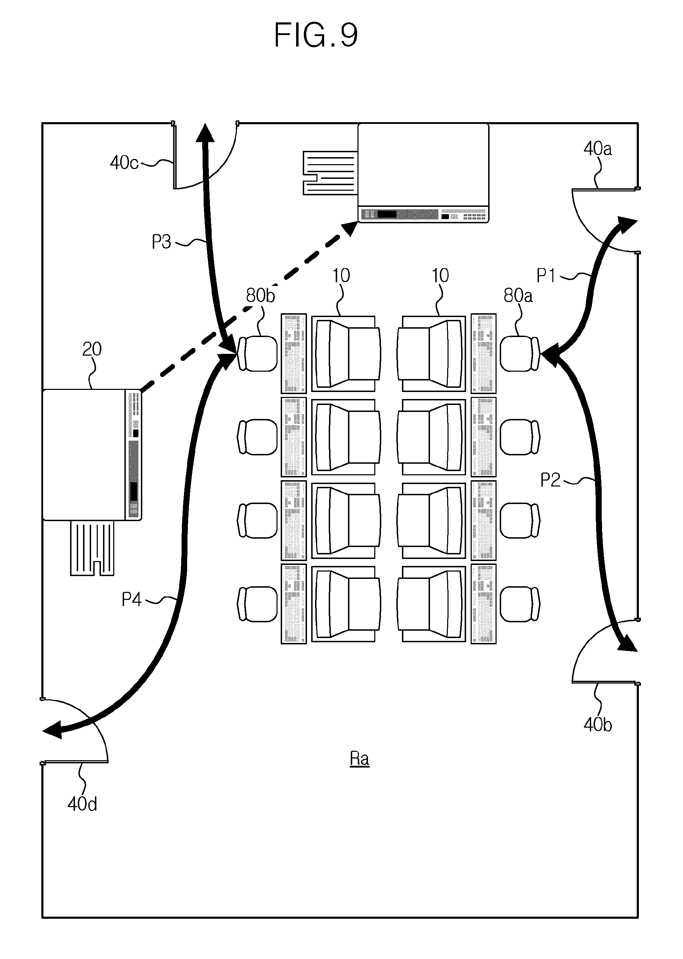

In FIG. 13, the image forming device 20 is installed between the security door 40a and the security door 40c in the office Ra in accordance with the proposal for the recommended installation place explained by using FIG. 9 and the like. In this case, because the user A hardly detours to stop by the image forming device 20 while moving from the seat 80a of the user A to the security door 40a, the movement distance of the user A becomes short as compared with the case shown in FIG. 12. Therefore, the installation place of the image forming device 20, which is shown in FIG. 13 is convenient for the user A.

Next, the detail operation of the system 5 according to this embodiment, will be explained.

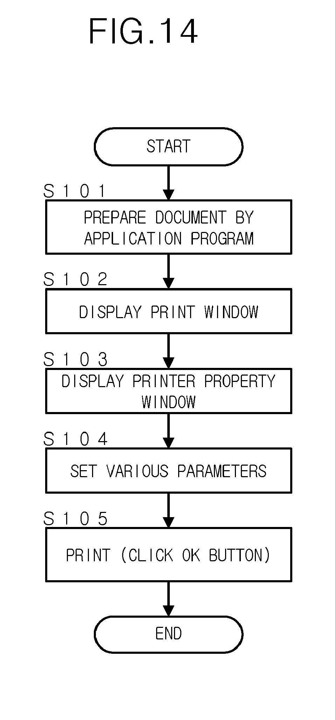

FIG. 14 shows the operation relating to the print instruction for printing a document, which is carried out by the user terminal 10. In this case, the operation is shown, in which the image forming device 20 is designated as a print destination and various parameters are set by the user terminal 10. In the user terminal 10, the document is prepared by using an application program in accordance with the user's operation (Step S101) . When the print menu of the application is opened, the user terminal 10 displays the print window 60 (See FIG. 3) in the display unit 17 (Step S102) . When the property button of the print window 60 is clicked, the user terminal 10 displays the printer property window 70 (See FIG. 4) in the display unit 17 (Step S103) . When the user terminal 10 receives the setting of various parameters via the printer property window 70 (Step S104) , the displayed contents of the display unit 17 return to the print window 60. By clicking the OK button of the print window 60, the user terminal 10 receives the print instruction (Step S105) .

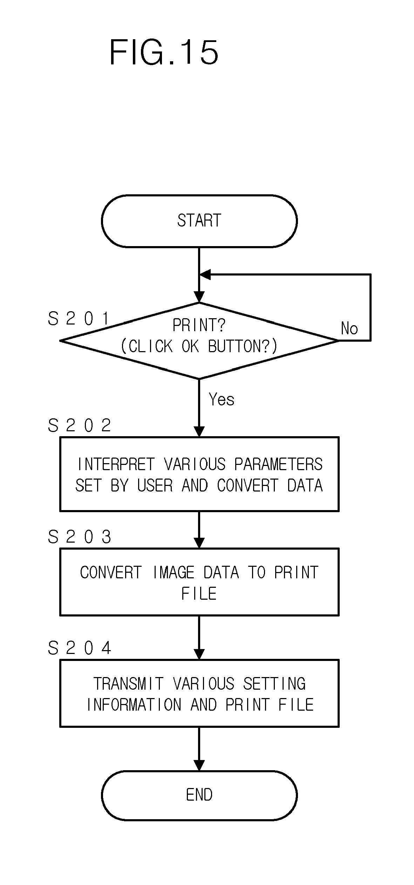

FIG. 15 shows the operation of the printer driver of the user terminal 10. When the print window 60 (See FIG. 3) explained by using FIG. 14 is displayed, the printer driver of the user terminal 10 monitors whether the user terminal 10 receives the print instruction or not (Step S201; No). When the user terminal 10 receives the print instruction (Step S201; Yes) , the printer driver interprets various parameters relating to the print of the document, which are set by the user via the print window 60 and the printer property window 70, and coverts the data (Step S202). Further, the printer driver converts the image data of the document to a print file (Step S203) . The printer driver generates a print job including various setting information and the print file which are obtained by converting the parameters and the image data of the document, and the terminal information (terminal ID) and the like, to transmit the generated print job to the designated image forming device 20 (Step S204).

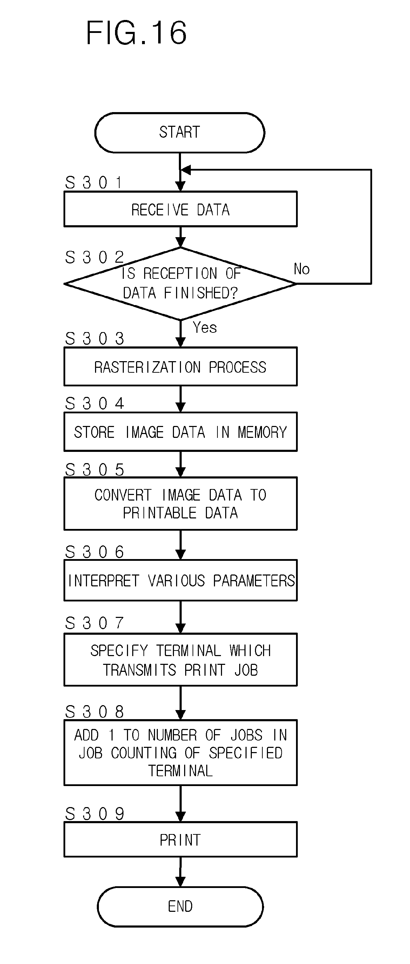

FIG. 16 shows the print operation for printing the print file received from the user terminal, which is carried out by the image forming device 20. The image forming device 20 receives the receiving request of the print job from the printer driver of the user terminal 10 (Step S301). The image forming device 20 responds to the receiving request and starts receiving the data (the print file, various setting information, the terminal information (terminal ID) and the like) of the print job transmitted from the user terminal 10 (Step S302; No) . When the reception of the data is finished (Step S302; Yes) , the image processing unit 32 carries out the rasterization processing for the received print file (Step S303), and stores the image data obtained by converting the print file to a bit map file, in the RAM 24 (Step S304). Further, in the printer unit 33, the image data is converted to a printable data form (Step S305).

The image forming device 20 analyzes the received various setting information (various parameters) (Step S306), and specifies the user terminal 10 which transmits the print job, from the received terminal information (Step S307). The image forming device 20 registers the terminal information (the identification information of the user terminal 10 which transmits the print job), the reception date of the print job, various setting information as the record information of the received print job in a job record table so as to relate them to each other.

The image forming device 20 counts the number of the print jobs by using a counter provided for each user terminal 10. In detail, the image forming device 20 adds "1" to the value of the counter for the print job, which corresponds to the user terminal 10 specified as one transmitting the print job (Step S308).

The image forming device 20 carries out the print processing (Step S309). Specifically, the printer unit 33 prints out the image on the recoding paper based on the image data stored in the RAM 24 (based on the data obtained by converting the image data into a printable data form in the printer unit 33). When the post-processing (staple, fold or the like) is set, the post-processing unit 34 carries out the post-processing for the printed recording paper outputted from the printer unit 33, and outputs the recording paper for which the post-processing is carried out.

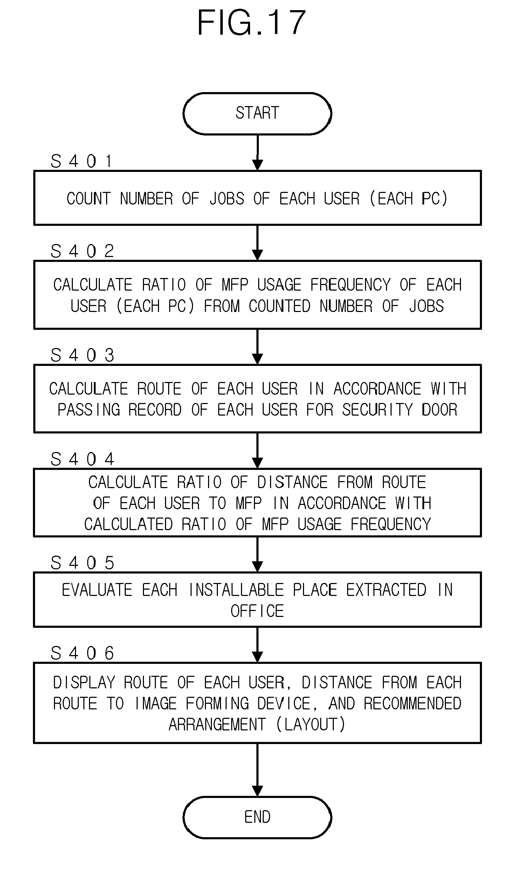

FIG. 17 shows the operation for proposing the recommended arrangement of the image forming device 20, which is carried out by the information collecting terminal 50. In this case, as an example, the operation for proposing the recommended arrangement in consideration of the image forming device usage frequency of each user as shown in FIG. 11, will be explained.

The information collecting terminal 50 collects the job record information of the jobs which the image forming device 20 executes during the period (the predetermined period, such as the past month) which is previously set by the administrator (or the user), from the image forming device 20. From the collected job record information, the information collecting terminal 50 counts the number of the jobs (the usage frequency of the print jobs) of each user terminal (Step S401). Further, the information collecting terminal 50 calculates the ratio of the image forming device usage frequency of each user (each user terminal 10) from the counted number of jobs of each user terminal (Step S402).

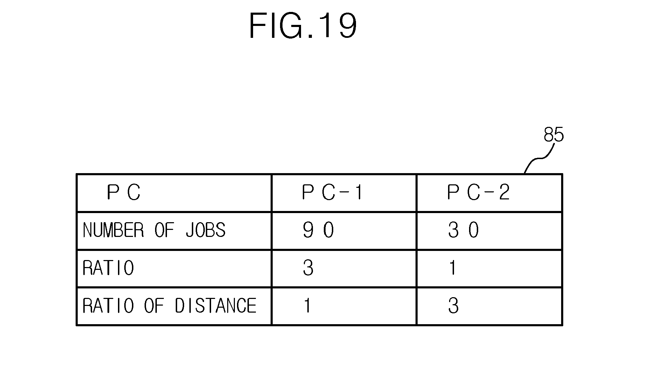

In FIG. 19, an example of the table 85 entering the counted number of jobs (the usage frequency of the print jobs) of each user terminal and the ratio thereof is shown. In the table 85, the number of jobs and the ratio thereof are stored with respect to each user terminal "PC-1", "PC-2" and the like. In this example, the number of jobs of PC-1 is 90 and the number of jobs of PC-2 is 30. The ratio between the number of jobs of PC-1 and the number of jobs of PC-2 is 3:1.

In FIG. 17, the information collecting terminal 50 calculates the route of each user in the office Ra in accordance with the passing record information of each user, which is inputted from the security doors 40, the position information of the entrances (the security doors 40 inputting the passing record information) in the floor information of the office Ra, which is stored in the hard disk drive 56 (or the nonvolatile memory 55) and the seat information of each user (Step S403) . Further, the information collecting terminal 50 calculates the ratio of the distance from the route of each user to the image forming device 20 in accordance with the ratio of the number of jobs (the usage frequency of the print jobs) of each user terminal, which is calculated in Step S402 (Step S404).

The above ratio of the distance is the target ratio, and is treated as the reciprocal ratio of the ratio of the number of jobs of each user terminal. The ratio of the distance is stored in the table 85 shown in FIG. 19. As an example of FIG. 19, in case that the ratio between the number of jobs of PC-1 and the number of jobs of PC-2 is 3:1, the ratio between the distance from the route of the user using PC-1 to the image forming device 20 and the distance from the route of the user using PC-2 to the image forming device 20 is 1:3. The ratio of the distance is stored in the table 85.

In FIG. 17, the information collecting terminal 50 evaluates each installable place of the image forming device 20, which is extracted from the layout map of the office Ra (Step S405). The information collecting terminal 50 displays the routes of each user, the distance from each route to the image forming device 20 and the recommended arrangement of the image forming device 20 on the layout map in the display unit 57 (Step S406). For example, the layout map shown in FIG. 11 is displayed.

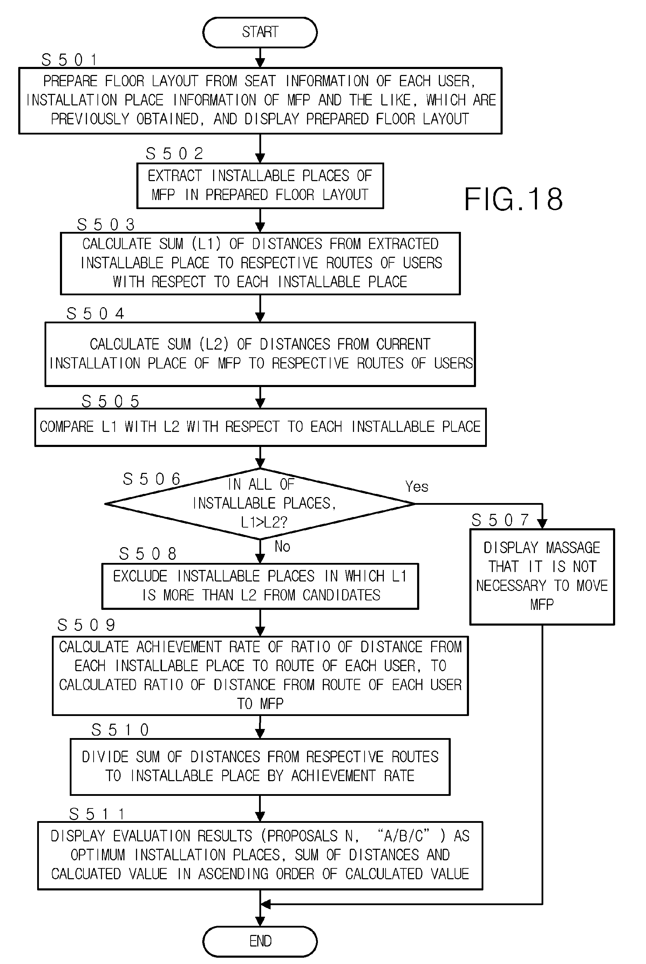

FIG. 18 shows the Step S405 and the Step S406 of FIG. 17 in detail. In FIG. 18, the example in which the more detail information is additionally displayed on the above layout map for proposing the recommended installation place of the image forming device 20, is shown.

The information collecting terminal 50 prepares the layout map of the office Ra by using the floor information (the information indicating the shape of the planer view of the floor, the positions and the sizes of the entrances (security doors 40) and the like), the seat information of each user (the information indicating the position and the shape of the planer view of the seat of each user, which is arranged in the office Ra), the installation place information of the image forming device 20 (the information indicating the current position and the shape of the planer view of the image forming device 20 installed in the office Ra) , the arrangement information of the office furniture (file shelf) (the information indicating the current position and the shape of the planer view of the office furniture arranged in the office Ra) and the like, which are stored in the hard disk drive 56 (or the nonvolatile memory 55) . Further, information collecting terminal 50 displays the prepared layout map in the display unit 57 (Step S501) .

The information collecting terminal 50 extracts the installable places of the image forming device 20 in the prepared layout map (Step S502). The method for automatically extracting the installable places is carried out as follows.

Here, the installable places are extracted from the current empty space in the layout map. Further, the conditions for extracting the installable places and the required information (the shape of the planer view and the size (area) of the image forming device 20 and the like) are previously inputted and set. For example, the places in which any one of the following conditions (1) to (3) is satisfied and the image forming device 20 can be installed, are extracted as the installable places.

(1) As the installable places, the information collecting terminal 50 extracts the places in which the image forming device 20 can be installed in the approximate middle position in the width direction (the lateral direction) of the wall so as to face the back surface of the image forming device 20 to the wall and so as to move the image forming device 20 close to the wall to direct the width direction of the image forming device 20 along the wall.

(2) As the installable places, the information collecting terminal 50 extracts the places in which the image forming device 20 can be installed by moving the image forming device 20 to the corner of the floor so as to face the back surface of the image forming device 20 to the wall and so as to move the image forming device 20 close to the wall to direct the width direction of the image forming device 20 along the wall.

(3) In case of the above (1) or (2), when the image forming device 20 interferes in the door (movable obstacle), the office furniture or the like, as the installable places, the information collecting terminal 50 extracts the places in which the image forming device 20 can be installed by shifting the image forming device 20 to the position in which the image forming device 20 does not interfere in the obstacle.

In the layout map of the office Ra, which is shown in FIG. 8, the installable places which satisfy one of the above conditions (1) to (3) can be extracted from the empty space S1 between the security door 40a and the security door 40b, the empty space S2 between the security door 40a and the security door 40c, the empty space S3 between the security door 40c and the current installation place, the empty space S4 between the security door 40b and the security door 40d, and the like. Here, the example in which the first to fourth candidates for the installable places are extracted from the empty spaces S1 to S4 in order, is explained.

As the condition for extracting the installable places, the following condition can be added. For example, the current installation place of the image forming device 20 can be extracted as the installable place. A movable obstacle is previously registered and the installable place can be extracted by treating the movable obstacle as though the obstacle does not exist. For example, in case that a file shelf is registered as the movable obstacle, the information collecting terminal 50 treats the file shelf as though the shelf does not exist. When the image forming device 20 can be installed in the space which is assumed by treating the file shelf as though the shelf does not exist, the information collecting terminal 50 can extract the above space as the installable place. Thereby, the number of the extracted installable places is increased, and the image forming device 20 can be installed more flexibly.

Further, the administrator (or the user) can previously set the installable places of the image forming device 20. For example, in the layout map of FIG. 8, at least one installable place which exists in the empty spaces S1 to S4 or the like can be previously set. In this case, the information collecting terminal 50 can be set so as to prioritize one of the above previous setting and the extracting of the installable places. Alternatively, the information collecting terminal 50 can be set so as to carry out the above extracting in addition to the above previous setting.

In FIG. 18, the information collecting terminal 50 calculates the sum (L1) of the distances from the extracted installable place to the respective routes of the users with respect to each installable place (Step S503). The distances used in this calculation are the above-described increased distances (the shortest distances). With respect to the user having a plurality of routes, the representative value of the increased distances of the respective routes is used.

Next, the information collecting terminal 50 calculates the sum (L2) of the distances (the shortest distances) from the current installation place of the image forming device 20 to the respective routes of the users (Step S504). Then, the information collecting terminal 50 compares the L1 with the L2 with respect to each installable place (Step S505) .

When the L1 is more than the L2 in all of the installable places (Step S506) , the massage that it is not necessary to move the image forming device 20 is displayed in the display unit 57 (Step S507). When one or more installable places in which the L1 is not more than the L2 exist (Step S506; No), the information collecting terminal 50 excludes the installable places in which the L1 is more than the L2 from the candidates (Step S508) . Although in this case, the information collecting terminal 50 excludes the installable places in which the L1 is more than the L2 from the candidates, the installable places in which the L1 is more than the L2 may be left as the candidates.

For example, with respect to each route of the user A and the user B, which is shown in FIG. 8, among the first to fourth candidates for the installable places, the third candidate for the installable place extracted from the empty space S3 and the fourth candidate for the installable place extracted from the empty space S4 are excluded because the L1 is more than the L2.

Next, the information collecting terminal 50 calculates the achievement rate of the ratio of the distance from each installable place to the route of each user (the ratio between the increased distances of the respective users) to the ratio of the distance from the route of each user to the image forming device 20 (the target ratio), which is calculated in the Step S404 of FIG. 17 (Step S509) .

For example, in the case in which PC-1 in the table 85 shown in FIG. 19 is the user terminal 10 used by the user A, which is shown in FIG. 7 and PC-2 is the user terminal 10 used by the user B, the calculation of the achievement rate is explained as follows. The target ratio (the reciprocal ratio of the ratio of the number of jobs between the respective user terminals) is the distance (LA) from the route of the user A to the image forming device 20 : the distance (LB) from the route of the user B to the image forming device 20. In case that the LB is equal to 1, the target ratio LA/LB is expressed as R2. The ratio between the distance from the installable place to the route of the user A and the distance from the installable place to the route of the user B (the ratio between the representative increased distance of the user A and the representative increased distance of the user B) is the representative increased distance (L$\alpha$) from the installable place to the route of the user A : the representative increased distance (L$\beta$) from the installable place to the route of the user B. In case that the L$\beta$ is equal to 1, the ratio L$\alpha$/L$\beta$ between the representative increased distance of the user A and the representative increased distance of the user B is expressed as R1.

The achievement rate of the ratio between the representative increased distance of the user A and the representative increased distance of the user B to the target ratio is expressed as R. The achievement rate R is calculated by using the equation (1) in case that R1 is not more than R2 (R1 $\leq$ R2), or by using the equation (2) in case that R1 is more than R2 (R1 > R2).

$$R = R1/R2 \times 100 \qquad \text{equation (1)}$$

$$R = (1/(R1/R2)) \times 100 \qquad \text{equation (2)}$$

For example, in case that the ratio of the number of jobs between the user A and the user B is 3:2, the target ratio is 2: 3 because the target ratio is the reciprocal ratio of the ratio of the number of jobs. Therefore, R2 is equal to 2/3.

In case of the first candidate for the installable place extracted from the empty space S1 between the security door 40a and the security door 40b, when the representative increased distance from the above installable place to the route of the user A is 0.8m and the representative increased distance from the above installable place to the route of the user B is 2.4m, the ratio of the distance is 1:3. Further, R1 is equal to 1/3. In case of the first candidate for the installable place, R1 is not more than R2 (R1 ≤ R2) . Therefore, the achievement rate R is calculated to be 50% by using the equation (1) (R = (1/3)/(2/3)X100 = 50%).

In case of the second candidate for the installable place extracted from the empty space S2 between the security door 40a and the security door 40c, when the representative increased distance from the above installable place to the route of the user A is 1m and the representative increased distance from the above installable place to the route of the user B is 2m, the ratio of the distance is 1:2. Further, R1 is equal to 1/2. In case of the second candidate for the installable place, R1 is not more than R2 (R1 ≤ R2). Therefore, the achievement rate R is calculated to be 75% by using the equation (1) (R = (1/2) / (2/3)X100 = 75%).

In accordance with the calculated achievement rate, each installable place is evaluated by classifying the installable place into the categories "A", "B" or "C". For example, the installable place having the achievement rate of not less than 70% is evaluated as "A". The installable place having the achievement rate of not less than 40% and less than 70% is evaluated as "B", and the installable place having the achievement rate of less than 39% is evaluated as "C". In case of the above first and second candidates for the installable place, the first candidate for the installable place has the achievement rate of 50% and is evaluated as "B". The second candidate for the installable place has the achievement rate of 75% and is evaluated as "A".

Next, the information collecting terminal 50 divides the sum of the distances (the increased distances) from the respective applied routes to the installable place by the achievement rate (Step S510).

In case of the first candidate for the installable place, the representative increased distance from the route of the user A to the first candidate for installable place is 0.8m and the representative increased distance from the route of the user B to the first candidate for installable place is 2.4m. The sum of the representative increased distances is 3.2m. By dividing the above sum by the achievement rate (50%), the value 6.4 is obtained (3.2/0.5=6.4) . In case of the second candidate for the installable place, the representative increased distance from the route of the user A to the second candidate for installable place is 1m and the representative increased distance from the route of the user B to the second candidate for installable place is 2m. The sum of the representative increased distances is 3m. By dividing the above sum by the achievement rate (75%), the value 4 is obtained (3/0.75=4).

Further, the example of the above calculation for the other installable places is shown as follows.

The distance from the route of the user A to the installable place: $L\alpha$
The distance from the route of the user B to the installable place: $L\beta$
The sum of the distances: L (=$L\alpha$ + $L\beta$)
The achievement rate: R
$L\alpha$ : $L\beta$ L/R
1m : 1m 2/0.25=8
1m : 2m 3/0.5=6
1m : 4m 5/1=5
2m : 8m 10/1=10

In this case, the installable place is evaluated by using the value calculated by dividing the sum of the distances by the achievement rate. The installable place may be evaluated by using the value: (the sum of the distances) / ( (the achievement rate) + (the predetermined Value)). The predetermined value is an optional value, for example, 0.5. By the predetermined value, the degree of the consideration for the evaluation using the above calculated value can be adjusted.

Next, the information collecting terminal 50 displays the proposals N (proposal 1, proposal 2, proposal 3, and the like) as the optimum installation places, the category "A", "B" or "C" of each installable place, which are the results of the evaluation, the sum of the distances, and the value calculated by dividing the sum of the distances by the achievement rate (Step S511) . The proposals N are displayed in ascending order of the above calculated value.

For example, the information collecting terminal 50 displays the second candidate for the installable place as the proposal 1. The information collecting terminal 50 displays the above category and the distances from the routes of the users, such as "The arrangement suitability in accordance with the route and the image forming device usage frequency of each user: 'A'", "The distance from the route of the user A is 1m and the distance from the route of the user B is 2m.". Further, the information collecting terminal 50 may display the sum of the distances, which is 3m, and the above calculated value which is 4. The information collecting terminal 50 displays the first candidate for the installable place as the proposal 2. The information collecting terminal 50 displays the above category and the distances from the routes of the users, such as "The arrangement suitability in accordance with the route and the image forming device usage frequency of each user: 'B'", "The distance from the route of the user A is 0.8m and the distance from the route of the user B is 2.4m.". Further, the information collecting terminal 50 may display the sum of the distances, which is 3.2m, and the above calculated value which is 6.4.

As described above, the information collecting terminal 50 calculates the recommended arrangement of the image forming device 20 so as to become close to the route of each user, in accordance with the route of each user in the office Ra in which the image forming device 20 is installed, and displays the calculated recommended arrangement. Thereby, it is possible to recommend (propose) the arrangement in which even though each user stops by the image forming device 20 during the user's movement, the excess movement is suppressed. In view of the recommended arrangement, the administrator or the like can install the image forming device 20 at a convenience place in which even though each user stops by the image forming device 20 during the user' s movement, the inconvenience caused to each user is reduced. Thereby, it is possible to improve the efficiency of the office work of all of the users in the office environment in which the image forming device 20 is shared by a plurality of users.

As shown in FIG. 11, in case that the recommended arrangement is calculated by weighting each user in accordance with the image forming device usage frequency (the number of jobs) of each user and is displayed, it is possible to recommend the arrangement of the image forming device 20 so as to install the image forming device 20 closer to the route of the user which uses the image forming device 20 with high frequency than the route of the user which uses the image forming device 20 with low frequency. By adopting the recommended arrangement, the inconvenience (the excess movement) caused to the user which uses the image forming device 20 with high frequency, by stopping by the image forming device 20 during the user's movement, is more suppressed. It is possible to improve the efficiency of the work for using the image forming device 20. Further, it is possible to equalize the inconvenience between the users, which is caused by stopping by the image forming device 20 during the user's movement. The efficiency of stopping by the image forming device 20 for all of the users, that is, the efficiency of the office work of all of the users sharing the image forming device 20 can be more improved.

By displaying the above various types of information on the layout map, it is possible to display the recommended arrangement of the image forming device 20 so as to instantly understand the arrangement. Further, the information collecting terminal 50 extracts a plurality of installable places in which the image forming device 20 can be installed, and evaluates each installable place to calculate and display the optimum installation place. Further, the information collecting terminal 50 displays the optimum installation place, the result of the evaluation for each installable place (the proposals N and the category "A/B/C"), the route of each user, the sum of the distances between the route of each user and the above place, and the like. As described above, by providing the information, such as the optimum installation place, the result of the evaluation for each installable place and the like, the administrator or the like can easily grasp the optimum installation place of the image forming device 20 from the above information and can easily compare and investigate each installable place.

[Second Embodiment]

In the second embodiment, the case in which the recommended arrangement of the image forming device 20 is proposed for the user having a plurality of routes in consideration of the route usage frequency of each route, will be explained.

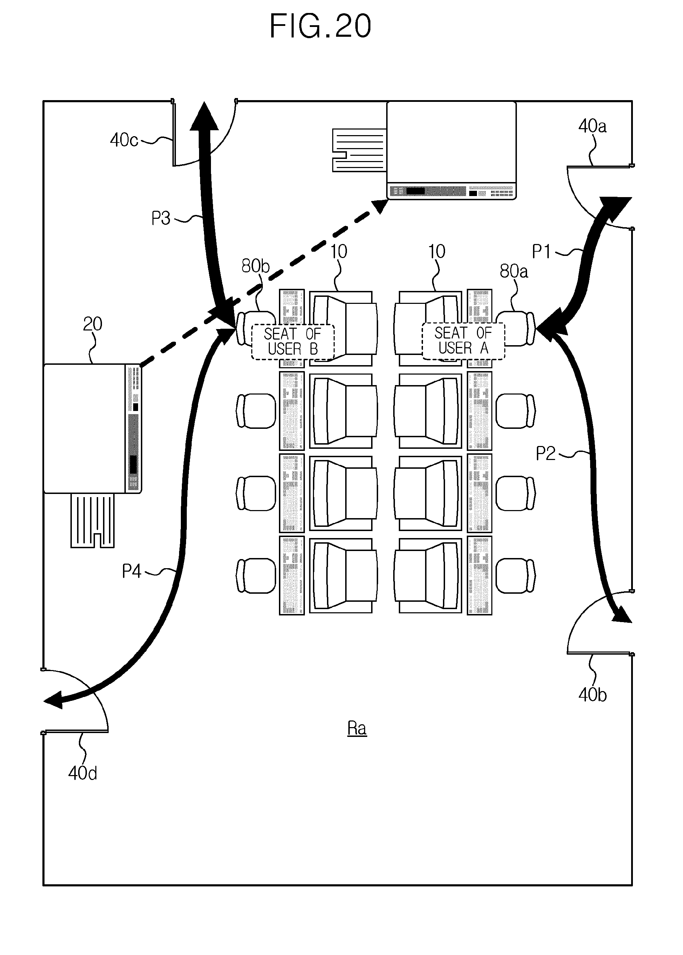

FIG. 20 shows an example of the layout map in which the recommended installation place calculated in consideration of the route usage frequency of each route is displayed. For example, with respect to the user A and the user B which belong to the office Ra explained in the first embodiment, in case of the user A, the passing frequency of the security door 40a is higher than the passing frequency of the security door 40b, and the route usage frequency of the route P1 is higher than the route usage frequency of the route P2. In case of the user B, the passing frequency of the security door 40c is higher than the passing frequency of the security door 40d, and the route usage frequency of the route P3 is higher than the route usage frequency of the route P4.

With respect to a plurality of routes which one user uses, the information collecting terminal 50 ranks the important degree of each route in descending order of the route usage frequency. In this embodiment, the information collecting terminal 50 determines that the route P1 has a higher important degree than the route P2 with respect to the user A, and that the route P3 has a higher important degree than the route P4 with respect to the user B. In the layout map displayed in the display unit 57, as shown in FIG. 20, the routes having the high important degree, in this embodiment, the route P1 and the route P3 are shown by bold lines. Further, the information collecting terminal 50 calculates the recommended installation place of the image forming device 20 so as to become closer to the route having the high important degree, and displays the calculated recommended installation place.

The method for calculating the representative increased distance from a plurality of routes which one user uses in consideration of the route usage frequency of each route is carried out as follows.

For example, in case that the representative value (the representative increased distance) of the respective increased distances from the routes P1 and P2 of the user A is calculated by obtaining an average value, the average value is calculated by weighting each increased distance from the routes P1 and P2 in accordance with each route usage frequency of the routes P1 and P2. The calculating equation for calculating the average value is expressed by the following equation (3) or the like.

The average value (the representative increased distance) of the respective increased distances from the routes P1 and P2: L$\alpha$

The increased distance from the route P1: A1

The increased distance from the route P2: A2

The route usage frequency (the number of times of the use) of the route P1: U1

The route usage frequency (the number of times of the use) of the route P2: U2

$$L\alpha = (A1 \times U1 + A2 \times U2)/(U1 + U2) \qquad equation\ (3)$$

Specifically, in case of A1=1m, A2=1.5m, U1=8 and U2=2, L$\alpha$ is calculated to be 1.1m by using the equation (3) (L$\alpha$ = (1 X 8 + 1.5 X 2)/(8 + 2) =11/10=1.1m).

On the other hand, when the average value of the respective increased distances from the routes P1 and P2 is calculated from the above increased distances without considering the route usage frequency of each route, the following average value is obtained.

$$L\alpha = (1 + 1.5)/2 = 1.25m$$

In case that one user uses three or more routes, all of the routes can be considered or only the predetermined number of routes which are selected in descending order of the route usage frequency can be considered.

[Third Embodiment]

In the third embodiment, the modified example in which the route of each user is estimated, will be explained. In this example, the configuration in which a wireless position detecting technology is used will be explained.

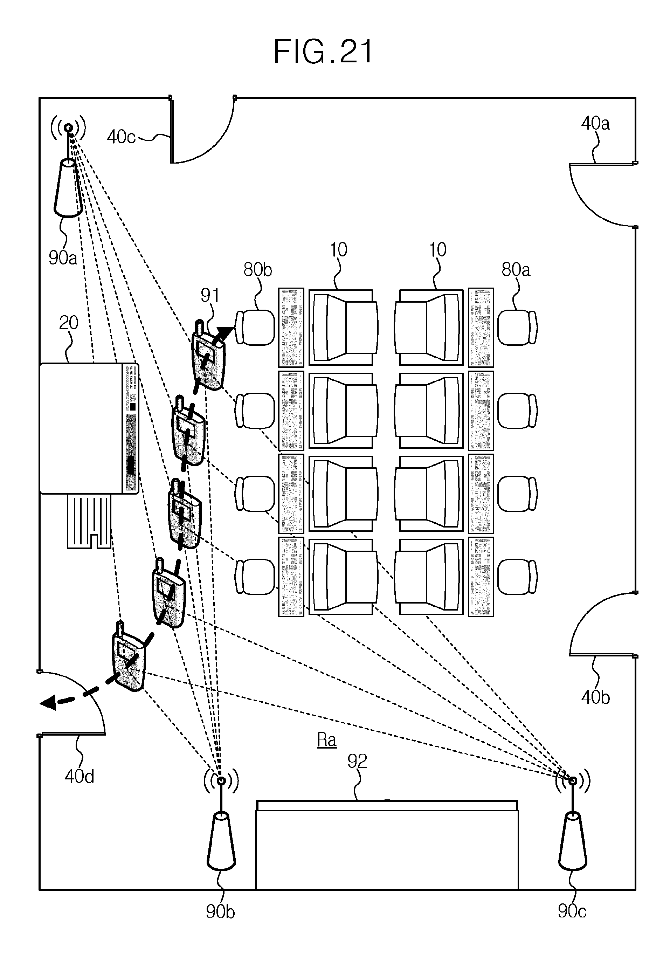

FIG. 21 shows an example of the configuration for estimating the route of each user by using the existing position detecting technology using the PHS (Personal Handyphone System) . In the office Ra, three PHS receivers 90a, 90b and 90c having the PHS position information communicating function are provided. The PHS receivers 90a, 90b and 90c are connected with the information collecting terminal 50 and are provided in the peripheral area of the office, such as at the corners, near the wall or the like, so as to be apart from each other.

Each user belonging to the office Ra carries a PHS terminal 91. The PHS receiver 90a, 90b and 90c periodically communicate with each PHS terminal 91 to measure the position of each PHS terminal 91 and input the position information of each PHS terminal 91 (each user) to the information collecting terminal 50. The information collecting terminal 50 estimates (detects) the route of each user by collecting the position information of each PHS terminal 91, which is inputted from the PHS receivers 90a, 90b and 90c.

As the wireless position detecting technology, instead of the PHS, the GPS (Global Positioning System) can be also used.

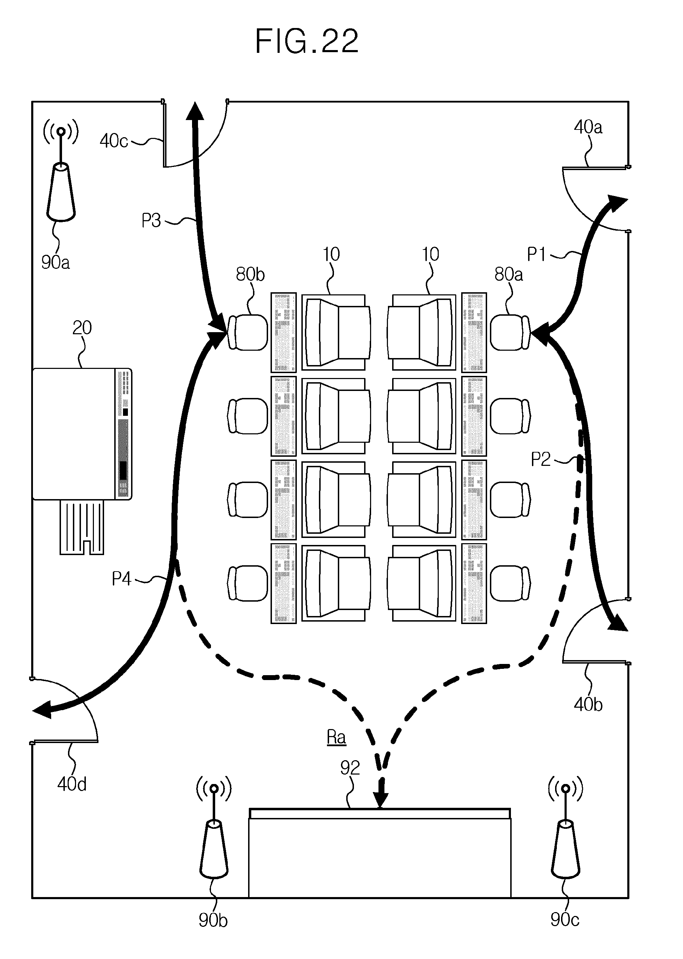

Instead of the above security doors 40, by the above wireless position detecting technology, the route of each user can be estimated. In this configuration, in addition to the route in which each user enters or exits the office Ra through the door, the various routes in which each user moves in the office Ra can be detected. As shown in FIG. 22, in case that a file shelf 92 is provided in the office Ra, it is possible to detect the route to the file shelf 92.

Thereby, in the proposal of the recommended arrangement of the image forming device 20, which is explained in the first and the second embodiments, it is possible to identify and detect various routes in the office Ra, and propose the recommended arrangement by suitably considering the identified and detected routes. In the example of FIG. 22, it is possible to propose the recommended arrangement in consideration of the route to the file shelf 92 or without considering the route to the file shelf 92.

As described above, the embodiments are explained by using the drawings. However, in the present invention, the concrete configuration is not limited to the above embodiments. In the present invention, various modifications of the above embodiments or the addition of various functions or the like to the embodiments can be carried out without departing from the gist of the invention.

In the above embodiments, the information collecting terminal 50 automatically recognizes the route of each user in accordance with the various types of information obtained from the security door or the PHS receiver. The information of the route which each user uses may be manually inputted to the information collecting terminal 50.

For example, in case of the office or the like in which the entrance and exit management is not carried out by the security doors or the like, each user, the administrator or the like inputs the information relating to the entrance (door) used for entering or exiting the office by each user to the information collecting terminal 50. The information collecting terminal 50 recognizes the route of each user by using the information which is manually inputted, instead of the passing record information of each user, which is inputted from the security doors as explained in the embodiments. Further, the information collecting terminal 50 may directly obtain the information relating to the route of each user by displaying the layout map of the office in a touch panel display of the information collecting terminal 50 to input the route of each user by tracing the route on the layout map of this touch panel display.

In the display for proposing the recommended arrangement of the image forming device 20, without using the layout map, the list of the result of the evaluation (the proposals N and the categories "A/B/C") obtained by evaluating the candidates for the positions (the current installation place and the other installable places) may be displayed.

When the recommended arrangement of the image forming device 20 is calculated, the route usage frequency of each user may be considered. In this case, the recommended arrangement of the image forming device 20 is calculated by weighting the route of each user in accordance with each route usage frequency. For example, when each of the user A and the user B uses one route, it is possible to recommend the arrangement of the image forming device so as to become close to the route having the highest route usage frequency between the two routes of the user A and the user B.

The proposal of the recommended arrangement of the image forming device 20 is not limited to office. The proposal may be applied to various areas in which a plurality of users share the image forming device 20, such as a laboratory, a workroom or the like.

In the above embodiments, the case in which the information collecting terminal 50 has the function of the layout support device is explained. However, the image forming device (the image forming device 20 of these embodiments) may have the function of the layout support device.

## Claims

1. A layout support device comprising:

   a route obtaining unit for each of users who use an image forming apparatus, for obtaining a route in a predetermined area in which the image forming device is installed;
   a recommended arrangement calculating unit for calculating a recommended arrangement of the image forming device in the predetermined area in accordance with a positional relation between the route of each user obtained by the route obtaining unit and a position in which the image forming device is installed; and
   a display unit for displaying the recommended arrangement calculated by the recommended arrangement calculating unit.

2. The layout support device of claim 1, wherein with respect to the user having a plurality of routes, each of the plurality of the routes is weighted in accordance with a route usage frequency of each of the plurality of routes.

3. The layout support device of claim 1 or 2, further comprising an image forming device usage frequency obtaining unit for obtaining an image forming device usage frequency of each user,
   wherein the recommended arrangement calculating unit calculates the recommended arrangement by weighting each user in accordance with the image forming device usage frequency of each user.

4. The layout support device of any one of claims 1 to 3, further comprising an installable place information obtaining unit for obtaining information indicating a plurality of installable places in which the image forming device is installable in the predetermined area,
   wherein the recommended arrangement calculating unit evaluates each of the plurality of installable places in accordance with an increased distance caused by stopping by the installable place while the user uses the route, and calculates the recommended arrangement by selecting an optimum installation place as the recommended arrangement among the plurality of installable places.

5. The layout support device of claim 4, wherein the increased distance is a shortest distance between the route and the installable place.

6. The layout support device of claim 4 or 5, wherein when the recommended arrangement calculating unit evaluates each of the plurality of installable places, the recommended arrangement calculating unit considers at least one of an achievement rate of a ratio between the increased distances calculated for the respective users to a target ratio, and a sum of the increased distances calculated for respective users.

7.  The layout support device of any one of claims 4 to 6, wherein with respect to the user having a plurality of routes, the recommended arrangement calculating unit calculates a representative increased distance which is the increased distance that is representative for the plurality of routes, and evaluates each of the plurality of installable places by using the representative increased distance.

8.  The layout support device of any one of claims 1 to 7, wherein the display unit displays the calculated recommended arrangement of the image forming device on a layout map.

9.  The layout support device of any one of claims 1 to 8, wherein the route obtaining unit obtains user's seat position information indicating a seat position of each user in the predetermined area, predetermined position information indicating a predetermined position in the predetermined area and user passing information indicating a user whose passing through the predetermined position is detected, and
the route obtaining unit recognizes a route obtained by connecting the seat position of the user indicated in the user passing information with the predetermined position, as the route of the user.

10. The layout support device of claim 9, wherein the predetermined position is an entrance for entering or exiting the predetermined area.

# FIG.1

5

SECURITY DOOR
(ENTRANCE AND
EXIT
MANAGEMENT)

40

USER TERMINAL (PC)

10   10   10   10

50

INFORMATION
COLLECTING
TERMINAL (PC)

LAN

2

Ra
(OFFICE)

40

SECURITY DOOR
(ENTRANCE AND
EXIT
MANAGEMENT)

20

IMAGE FORMING DEVICE (MFP)

EP 2 458 534 A1

# FIG.2

USER TERMINAL
(PC)

CPU

DISPLAY UNIT

OPERATING UNIT

NETWORK COMMUNICATION UNIT

ROM

RAM

NONVOLATILE MEMORY

HARD DISK DRIVE

# FIG. 3

60

PRINTER
PRINTER NAME | M F P ＊ ＊ ＊ ＊ | V | | PROPERTY
STATE
TYPE | | SEARCH FOR PRINTER
LOCATION

NUMBER OF COPIES

PRINT RANGE

ALL (A)
CURRENT PAGE (E)
PAGE DESIGNATION (G)

ENLARGEMENT/REDUCTION

PRINT OBJECT | DOCUMENT

PRINT DESIGNATION(R) | ALL PAGES

OPTION

PAGES PER SHEET(H) | 1 PAGE
PAPER SIZE DESIGNATION(Z) | NO ZOOM DESIGNATION

O K | CANCEL

# FIG.4

70

```
┌─────────────────────────────────────────────────────────────┐
│  PRINTER DRIVER                                               │
├──────────────────────────┬──────────────────────────────────┤
│                          │                                    │
│                          │   NUMBER OF COPIES [    1     ][▲▼]│
│      ┌────────┐          │      ORIGINAL SIZE [   A4     ][▼] │
│      │        │          │  OUTPUT PAPER SIZE [  Tray1   ][▼] │
│      │        │          │  IMAGE ORIENTATION [ PORTRAIT ][▼] │
│      └────────┘          │        PRINT SIDE  [ 1-SIDED  ][▼] │
│                          │           LAYOUT   [   1Up    ][▼] │
│                          │           STAPLE   [   NO     ][▼] │
│                          │            FOLD    [   NO     ]    │
│                          │            ZOOM    [   100%   ]    │
│                          │                                    │
├──────────────────────────┴──────────────────────────────────┤
│  (  OK  )    ( CANCEL )    ( APPLY )    ( HELP )              │
└─────────────────────────────────────────────────────────────┘
```

# FIG.5

IMAGE FORMING DEVICE (MFP) — 20

21 — CPU

22

29 — FACSIMILE COMMUNICATION UNIT

30 — NETWORK COMMUNICATION UNIT

31 — SCANNER UNIT

32 — IMAGE PROCESSING UNIT

33 — PRINTER UNIT

34 — POST-PROCESSING UNIT

ROM — 23

RAM — 24

NONVOLATILE MEMORY — 25

HARD DISK DRIVE — 26

DISPLAY UNIT — 27

OPERATING UNIT — 28

# FIG.6

50

51

INFORMATION
COLLECTING
TERMINAL (PC)

CPU

52

57 — DISPLAY UNIT

58 — OPERATING UNIT

59 — NETWORK COMMUNICATION UNIT

ROM — 53

RAM — 54

NONVOLATILE MEMORY — 55

HARD DISK DRIVE — 56

# FIG.7

# FIG.8

# FIG.9

# FIG.10

# FIG.11

# FIG.12

Rb
(CONFERENCE ROOM)

40c

20

40a

10

SEAT OF
USER A

80a

40b

Ra

40d

# FIG.13

Rb
(CONFERENCE ROOM)

40c

40a

20

10

SEAT OF
USER A

80a

40b

40d

Ra

# FIG.14

START

S101
PREPARE DOCUMENT BY
APPLICATION PROGRAM

S102
DISPLAY PRINT WINDOW

S103
DISPLAY PRINTER PROPERTY
WINDOW

S104
SET VARIOUS PARAMETERS

S105
PRINT (CLICK OK BUTTON)

END

# FIG.15

START

S201      PRINT?
(CLICK OK BUTTON?)     No

Yes

S202
INTERPRET VARIOUS PARAMETERS
SET BY USER AND CONVERT DATA

S203
CONVERT IMAGE DATA TO PRINT
FILE

S204
TRANSMIT VARIOUS SETTING
INFORMATION AND PRINT FILE

END

# FIG.16

```
                    ┌──────────────┐
                    │    START     │
                    └──────────────┘
                            │
S 3 0 1                     ▼
              ┌──────────────────────────┐
              │       RECEIVE DATA        │◄──────────┐
              └──────────────────────────┘           │
                            │                         │
S 3 0 2                     ▼                         │
                    ╱─────────────╲          No       │
              ╱─────  IS RECEPTION OF  ─────╲─────────┘
              ╲       DATA FINISHED?        ╱
                    ╲─────────────╱
                            │ Yes
S 3 0 3                     ▼
              ┌──────────────────────────┐
              │    RASTERIZATION PROCESS   │
              └──────────────────────────┘
                            │
S 3 0 4                     ▼
              ┌──────────────────────────┐
              │  STORE IMAGE DATA IN MEMORY │
              └──────────────────────────┘
                            │
S 3 0 5                     ▼
              ┌──────────────────────────┐
              │   CONVERT IMAGE DATA TO    │
              │      PRINTABLE DATA        │
              └──────────────────────────┘
                            │
S 3 0 6                     ▼
              ┌──────────────────────────┐
              │  INTERPRET VARIOUS PARAMETERS │
              └──────────────────────────┘
                            │
S 3 0 7                     ▼
              ┌──────────────────────────┐
              │   SPECIFY TERMINAL WHICH   │
              │    TRANSMITS PRINT JOB     │
              └──────────────────────────┘
                            │
S 3 0 8                     ▼
              ┌──────────────────────────┐
              │  ADD 1 TO NUMBER OF JOBS IN │
              │  JOB COUNTING OF SPECIFIED  │
              │        TERMINAL            │
              └──────────────────────────┘
                            │
S 3 0 9                     ▼
              ┌──────────────────────────┐
              │          PRINT            │
              └──────────────────────────┘
                            │
                            ▼
                    ┌──────────────┐
                    │     END      │
                    └──────────────┘
```

# FIG.17

START

S 4 0 1

COUNT NUMBER OF JOBS OF EACH USER (EACH PC)

S 4 0 2

CALCULATE RATIO OF MFP USAGE FREQUENCY OF EACH USER (EACH PC) FROM COUNTED NUMBER OF JOBS

S 4 0 3

CALCULATE ROUTE OF EACH USER IN ACCORDANCE WITH PASSING RECORD OF EACH USER FOR SECURITY DOOR

S 4 0 4

CALCULATE RATIO OF DISTANCE FROM ROUTE OF EACH USER TO MFP IN ACCORDANCE WITH CALCULATED RATIO OF MFP USAGE FREQUENCY

S 4 0 5

EVALUATE EACH INSTALLABLE PLACE EXTRACTED IN OFFICE

S 4 0 6

DISPLAY ROUTE OF EACH USER, DISTANCE FROM EACH ROUTE TO IMAGE FORMING DEVICE, AND RECOMMENDED ARRANGEMENT (LAYOUT)

END

FIG.18

START

S501
PREPARE FLOOR LAYOUT FROM SEAT INFORMATION OF EACH USER, INSTALLATION PLACE INFORMATION OF MFP AND THE LIKE, WHICH ARE PREVIOUSLY OBTAINED, AND DISPLAY PREPARED FLOOR LAYOUT

S502
EXTRACT INSTALLABLE PLACES OF MFP IN PREPARED FLOOR LAYOUT

S503
CALCULATE SUM (L1) OF DISTANCES FROM EXTRACTED INSTALLABLE PLACE TO RESPECTIVE ROUTES OF USERS WITH RESPECT TO EACH INSTALLABLE PLACE

S504
CALCULATE SUM (L2) OF DISTANCES FROM CURRENT INSTALLATION PLACE OF MFP TO RESPECTIVE ROUTES OF USERS

S505
COMPARE L1 WITH L2 WITH RESPECT TO EACH INSTALLABLE PLACE

S506  IN ALL OF INSTALLABLE PLACES, L1>L2?  Yes

S507
DISPLAY MASSAGE THAT IT IS NOT NECESSARY TO MOVE MFP

No

S508
EXCLUDE INSTALLABLE PLACES IN WHICH L1 IS MORE THAN L2 FROM CANDIDATES

S509
CALCULATE ACHIEVEMENT RATE OF RATIO OF DISTANCE FROM EACH INSTALLABLE PLACE TO ROUTE OF EACH USER, TO CALCULATED RATIO OF DISTANCE FROM ROUTE OF EACH USER TO MFP

S510
DIVIDE SUM OF DISTANCES FROM RESPECTIVE ROUTES TO INSTALLABLE PLACE BY ACHIEVEMENT RATE

S511
DISPLAY EVALUATION RESULTS (PROPOSALS N, "A/B/C") AS OPTIMUM INSTALLATION PLACES, SUM OF DISTANCES AND CALCUATED VALUE IN ASCENDING ORDER OF CALCULATED VALUE

END

# FIG.19

85

| P C | P C-1 | P C-2 |
|---|---|---|
| NUMBER OF JOBS | 9 0 | 3 0 |
| RATIO | 3 | 1 |
| RATIO OF DISTANCE | 1 | 3 |

# FIG.20

# FIG.21

# FIG.22

Europäisches
Patentamt

European
Patent Office

Office européen
des brevets

# EUROPEAN SEARCH REPORT

**Application Number**

EP 11 18 9006

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | A notorious computer system, as known before the priority date of the application, is considered relevant prior art in respect of which an inventive step cannot be acknowledged. The claimed subject matter, with due regard to the description and drawings, relates inter alia to processes comprised in the list of subject matter and activities excluded from patentability under Art. 52(2) and (3) EPC. The Applicant is advised that in accordance with the established practice of the EPO no search need be performed in respect of those aspects of the invention. The only identifiable technical aspects of the claimed invention relate to the use of conventional, general purpose data processing technology for processing data of an inherently non-technical nature. The information technology employed is considered to have been generally known as it was widely available to everyone at the date of filing/priority of the present application. The notoriety of such prior art cannot reasonably be contested. Accordingly, no documentary evidence is considered required, as the technical aspects identified in the present application (Art. 92 EPC) are considered part of the common general knowledge. For further details see the Notice from the European Patent Office dated 1 October 2007 (OJ 11/2007; p594-600) and the accompanying opinion.<br>----- | 1-10 | INV.<br>G06Q10/00<br><br>TECHNICAL FIELDS SEARCHED (IPC)<br><br>G06Q |

The present search report has been drawn up for all claims

| Place of search | Date of completion of the search | Examiner |
|---|---|---|
| Munich | 20 January 2012 | González, Gonzalo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**EP 2 458 534 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001184375 A